# EUROPEAN PATENT APPLICATION

(11) **EP 4 510 805 A2**
(43) Date of publication of application: **19.02.2025**
(21) Application number: 25150170.6
(22) Date of filing: 03.01.2025
(51) Int. Cl.: H10F 10/14, H10F 71/00, H10F 77/30

(54) **SOLAR CELL, PHOTOVOLTAIC MODULE, AND PHOTOVOLTAIC SYSTEM**

(30) Priority: 17.05.2024 CN 202410612515
(71) Applicant: Trina Solar Co., Ltd, Changzhou, Jiangsu 213031 (CN)
(72) Inventor: GAO, Jifan, Changzhou 213031 (CN); WANG, Zigang, Changzhou 213031 (CN)
(74) Representative: Arnold & Siedsma

(57) **Abstract**

The present application relates to a solar cell, a photovoltaic module, and a photovoltaic system. The solar cell includes an n-type semiconductor substrate, a first tunneling passivation structure, a second tunneling passivation structure, a third tunnel layer, and a third passivation layer. The n-type semiconductor substrate includes a first surface and a second surface opposite to each other. The second surface includes a passivation contact region and a passivation region adjacent to each other. The first tunneling passivation structure includes a first tunnel layer and a first passivation contact layer stacked in a direction away from the semiconductor substrate. The second tunneling passivation structure includes a second tunnel layer and a second passivation contact layer stacked on the passivation contact region. The third tunnel layer and the third passivation layer are stacked on the passivation region of the second surface.

## Description

### TECHNICAL FIELD

The present application relates to the field of solar cell technology, particularly to solar cells, preparation methods thereof, photovoltaic modules, and photovoltaic systems.

### BACKGROUND

A solar cell is a device that directly converts light energy into electrical energy through the photoelectric effect. Generally, the solar cell is manufactured by using semiconductor processing technology to form a p-n junction adjacent to a surface of a semiconductor wafer or substrate. A tunnel oxide passivated contact (TOPCon) cell is a type of solar cell including a tunnel oxide layer as a passivation layer structure. The tunnel oxide layer allows majority carriers (e.g., electrons) to tunnel into the polysilicon layer while blocking the recombination of minority carriers (e.g., holes), thereby allowing the majority carriers to be laterally transported in the polysilicon layer and collected by the metal electrodes, which increase the open-circuit voltage and short-circuit current of the cell.

### SUMMARY

In view of the above, a solar cell, a preparation method thereof, a photovoltaic module, and a photovoltaic system are provided.

In a first aspect, an embodiment of the present application provides a method for preparing a solar cell, including:
providing an n-type semiconductor substrate, the semiconductor substrate including a first surface and a second surface opposite to each other, the second surface including a passivation contact region and a passivation region adjacent to each other;
forming a first tunneling passivation structure on the first surface, the first tunneling passivation structure including a first tunnel layer and a first passivation contact layer stacked in a direction away from the semiconductor substrate, the doping type of the first passivation contact layer is p-type;
forming a second tunnel material layer and a second passivation contact material layer stacked on the second surface;
oxidizing a surface of the second passivation contact material layer located in the passivation contact region to form a mask layer; and
processing the second passivation contact material layer located in the passivation region through the mask layer to form a second tunneling passivation structure located in the passivation contact region, wherein the second tunneling passivation structure includes a second tunnel layer and a second passivation contact layer, and the doping type of the second passivation contact layer is n-type.

In the method for preparing the solar cell provided by the embodiment of the present application, on the one hand, the formation of the bifacial tunneling passivation structure of the solar cell can effectively improve the efficiency of the solar cell; on the other hand, by oxidizing the surface of the second passivation contact material layer located in the passivation contact region, a mask layer can be formed on the second passivation contact material layer located in the passivation contact region. The second passivation contact material layer located in the passivation region can be processed through the mask layer, thereby reducing the manufacturing cost of the solar cell compared with the method involving large-area laser etching in formation of a mask layer in the related art.

In an embodiment, oxidizing the surface of the second passivation contact material layer located in the passivation contact region to form the mask layer includes:

laser oxidizing the surface of the second passivation contact material layer located in the passivation contact region to form the mask layer.

In an embodiment, forming the first tunneling passivation structure on the first surface includes:
forming a first tunnel material layer on the first surface and the second surface;
forming a first passivation contact material layer and a first medium layer stacked on the first tunnel material layer; and
removing the first tunnel material layer, the first passivation contact material layer, and the first medium layer from the second surface.

In an embodiment, forming the first passivation contact material layer and the first medium layer stacked on the first tunnel material layer includes:
forming the first passivation contact material layer on the first tunnel material layer;
performing a first heat treatment to the first passivation contact material layer to activate a dopant in the first passivation contact material layer or to diffuse the dopant into the first passivation contact material layer, and to form the first medium layer on the first passivation contact material layer.

In an embodiment, forming the first passivation contact material layer and the first medium layer stacked on the first tunnel material layer includes:
forming the first passivation contact material layer containing a dopant on the first tunnel material layer; and
forming the first medium layer on the first passivation contact material layer.

In an embodiment, forming the second tunnel material layer and the second passivation contact material layer stacked on the second surface includes:
forming the second tunnel material layer on the second surface; and
forming the second passivation contact material layer and a second medium layer stacked on the first surface and the second surface.

In an embodiment, forming the second passivation contact material layer and the second medium layer stacked on the first surface and the second surface includes:
forming the second passivation contact material layer on the first surface and the second surface;
performing a second heat treatment to the second passivation contact material layer to activate a dopant in the second passivation contact material layer or to diffuse a dopant into the second passivation contact material layer, and to form the second medium layer on the second passivation contact material layer.

In an embodiment, forming the second passivation contact material layer and the second medium layer stacked on the first surface and the second surface includes:
forming the second passivation contact material layer containing a dopant on the first surface and the second surface; and
forming the second medium layer on the second passivation contact material layer.

In an embodiment, forming the second passivation contact material layer containing the dopant on the first surface and the second surface includes:
forming a first passivation contact material sub-layer on the first surface and the second surface;
forming a barrier material layer on the first passivation contact material sub-layer; and
forming a second passivation contact material sub-layer on the barrier material layer to form the second passivation contact material layer.

In an embodiment, after forming the second passivation contact material layer and the second medium layer stacked on the first surface and the second surface, the method further includes:
performing a third heat treatment on the first tunneling passivation structure, the second tunnel material layer, and the second passivation contact material layer.

In an embodiment, after forming the second passivation contact material layer and the second medium layer stacked on the first surface and the second surface, the method further includes:
removing the second medium layer and removing the second passivation contact material layer from the first surface.

In an embodiment, removing the second medium layer and removing the second passivation contact material layer from the first surface includes:
removing the second medium layer from the first surface;
removing the second passivation contact material layer from the first surface; and
removing the second medium layer from the second surface.

In an embodiment, processing the second passivation contact material layer located in the passivation region through the mask layer to form the second tunneling passivation structure located in the passivation contact region includes:
removing the second tunnel material layer and the second passivation contact material layer located in the passivation region through the mask layer to form the second tunneling passivation structure located in the passivation contact region.

In an embodiment, processing the second passivation contact material layer located in the passivation region through the mask layer to form the second tunneling passivation structure located in the passivation contact region includes:
thinning the second passivation contact material layer located in the passivation region through the mask layer to form the second tunneling passivation structure located in the passivation contact region, and forming a third tunnel layer and a third passivation layer stacked in the passivation region.

In an embodiment, after forming the second passivation contact material layer and the second medium layer stacked on the first surface and the second surface, and before oxidizing the surface of the second passivation contact material layer located in the passivation contact region to form the mask layer, the method further includes:
removing the second medium layer.

In an embodiment, processing the second passivation contact material layer located in the passivation region through the mask layer to form the second tunneling passivation structure located in the passivation contact region includes:
removing the second tunnel material layer and the second passivation contact material layer located in the passivation region;
performing a fourth heat treatment on the first tunneling passivation structure, the second tunnel material layer, and the second passivation contact material layer; and
removing a heat treatment by-product from the semiconductor substrate to form the second tunneling passivation structure.

In an embodiment, after forming the first tunneling passivation structure on the first surface and before forming the second tunnel material layer and the second passivation contact material layer stacked on the second surface, the method further includes:
texturizing the semiconductor substrate to form pyramidal textured structures in the second surface.

In a second aspect, an embodiment of the present application provides a solar cell, including:
an n-type semiconductor substrate including a first surface and a second surface opposite to each other, the second surface including a passivation contact region and a passivation region adjacent to each other;
a first tunneling passivation structure disposed on the first surface, the first tunneling passivation structure including a first tunnel layer and a first passivation contact layer stacked in a direction away from the semiconductor substrate, a doping type of the first passivation contact layer is p-type; and
a second tunneling passivation structure disposed on the second surface and located in the passivation contact region of the second surface, the second tunneling passivation structure including a second tunnel layer and a second passivation contact layer stacked on the passivation contact region;
wherein when forming the second tunneling passivation structure, a surface of a second passivation contact material layer located in the passivation contact region is oxidized to form a mask layer; the second tunneling passivation structure is formed by processing the second passivation contact material layer located in the passivation region through the mask layer.

In an embodiment, a first distance between the passivation contact region of the second surface and the first surface is represented by L₁, and a second distance between the passivation region of the second surface and the first surface is represented by L₂, L₁ and L₂ satisfy 0 ≤ L₁-L₂ ≤ 1 µm.

In an embodiment, a thickness of the second passivation contact layer is in a range from 90 nm to 300 nm.

In an embodiment, the semiconductor substrate includes a first diffusion region, and an orthographic projection of the second tunneling passivation structure projected on the semiconductor substrate overlaps with the first diffusion region.

In an embodiment, the semiconductor substrate includes a second diffusion region, the second diffusion region is in contact with the first diffusion region, and an orthographic projection of the second tunneling passivation structure projected on the semiconductor substrate does not overlap with the second diffusion region.

In an embodiment, the solar cell further includes a third tunnel layer and a third passivation layer, the third tunnel layer and the third passivation layer are stacked on the passivation region of the second surface.

In an embodiment, the third tunnel layer and the second tunnel layer are one integrated structure; and/or
the third passivation layer and the second passivation contact layer are one integrated structure.

In an embodiment, a thickness of the third passivation layer is less than a thickness of the second passivation contact layer.

In an embodiment, a thickness ratio of the second passivation contact layer to the third passivation layer is in a range from 5 to 30.

In an embodiment, the second passivation contact layer includes a first passivation contact sub-layer, a barrier layer, and a second passivation contact sub-layer, stacked in a direction away from the semiconductor substrate.

In a third aspect, an embodiment of the present application provides a photovoltaic module, including the solar cell described in the second aspect.

In a fourth aspect, an embodiment of the present application provides a photovoltaic system, including the photovoltaic module described in the third aspect.

In the solar cell, the photovoltaic module, and the photovoltaic system provided by the embodiments of the present application, on the one hand, the bifacial tunneling passivation structure of the solar cell can effectively improve the efficiency of the solar cell compared to a mono-facial TOPCon cell structure; on the other hand, the manufacturing cost of the solar cell can be reduced.

### BRIEF DESCRIPTION OF THE DRAWINGS

In order to illustrate the embodiments of the present disclosure more clearly, the drawings used in the embodiments or exemplary examples will be described briefly. Apparently, the following described drawings are merely some embodiments of the present application, and other drawings can be derived by those of ordinary skill in the art without any creative efforts.
FIG. 1 shows a flow chart of a method for preparing a solar cell according to an embodiment of the present application.
FIG. 2 shows a flow chart of an embodiment of step S200 in FIG. 1.
FIG. 3 shows a flow chart of an embodiment of step S220 in FIG. 2.
FIG. 4 shows a flow chart of another embodiment of step S220 in FIG. 2.
FIG. 5 shows a flow chart of an embodiment of step S230 in FIG. 2.
FIG. 6 shows a flow chart of an embodiment of step S300 in FIG. 1.
FIG. 7 shows a flow chart of an embodiment of step S320 in FIG. 6.
FIG. 8 shows a flow chart of another embodiment of step S320 in FIG. 6.
FIG. 9 shows a flow chart of step S330A in the method for preparing the solar cell according to an embodiment of the present application.
FIG. 10 shows a flow chart of optional steps following step S500 in FIG. 1.
FIG. 11 shows a flow chart of an embodiment of step S500 in FIG. 1.
FIG. 12 shows a flow chart of an embodiment of step S321B in FIG. 8.
FIG. 13 is a schematic sectional view of a semiconductor substrate in the method for preparing the solar cell according to an embodiment of the present application.
FIG. 14 is a schematic sectional view of a structure obtained after forming a first tunnel material layer and a first passivation contact material layer in the method for preparing the solar cell according to an embodiment of the present application.
FIG. 15 is a schematic sectional view of a structure obtained after forming a first medium layer in the method for preparing the solar cell according to an embodiment of the present application.
FIG. 16 is a schematic sectional view of a structure obtained after removing part of the first medium layer in the method for preparing the solar cell according to an embodiment of the present application.
FIG. 17 is a schematic sectional view of a structure obtained after forming a first tunneling passivation structure in the method for preparing the solar cell according to an embodiment of the present application.
FIG. 18 is a schematic sectional view of a structure obtained after forming a second tunnel material layer and a second passivation contact material layer in the method for preparing the solar cell according to an embodiment of the present application.
FIG. 19 is a schematic sectional view of a structure obtained after forming a second medium layer in the method for preparing the solar cell according to an embodiment of the present application.
FIG. 20 is a schematic sectional view of a structure obtained after removing part of the second medium layer in the method for preparing the solar cell according to an embodiment of the present application.
FIG. 21 is a schematic sectional view of a structure obtained after removing part of the second tunnel material layer and part of the second passivation contact material layer in the method for preparing the solar cell according to an embodiment of the present application.
FIG. 22 is a schematic sectional view of a structure obtained after entirely removing the second medium layer in the method for preparing the solar cell according to an embodiment of the present application.
FIG. 23 is a schematic sectional view of a structure obtained after forming a mask layer in the method for preparing the solar cell according to an embodiment of the present application.
FIG. 24 is a schematic sectional view of a structure obtained after forming a second tunneling passivation structure in the method for preparing the solar cell according to an embodiment of the present application.
FIG. 25 is a schematic sectional view of a structure obtained after forming a first passivation layer and a second passivation layer in the method for preparing the solar cell according to an embodiment of the present application.
FIG. 26 is a schematic sectional view of a structure obtained after forming a first anti-reflective layer and a second anti-reflective layer in the method for preparing the solar cell according to an embodiment of the present application.
FIG. 27 is a schematic sectional view of a structure obtained after forming a first electrode and a second electrode in the method for preparing the solar cell according to an embodiment of the present application.
FIG. 28 is a schematic sectional view of a structure obtained after forming the second medium layer, the second tunnel material layer, and the second passivation contact material layer in the method for preparing the solar cell according to another embodiment of the present application.
FIG. 29 is a schematic sectional view of a structure obtained after entirely removing the second medium layer in the method for preparing the solar cell according to another embodiment of the present application.
FIG. 30 is a schematic sectional view of a structure obtained after forming the mask layer in the method for preparing the solar cell according to another embodiment of the present application.
FIG. 31 is a schematic sectional view of a structure obtained after forming the second tunneling passivation structure in the method for preparing the solar cell according to another embodiment of the present application.
FIG. 32 is a schematic sectional view of a structure obtained after forming a heat treatment by-product in the method for preparing the solar cell according to another embodiment of the present application.
FIG. 33 is a schematic sectional view of a structure obtained after removing the heat treatment by-product in the method for preparing the solar cell according to another embodiment of the present application.
FIG. 34 is a schematic sectional view of a structure obtained after forming a first passivation contact material sub-layer, a barrier material layer, and a second passivation contact material sub-layer in the method for preparing the solar cell according to another embodiment of the present application.
FIG. 35 is a schematic sectional view of a structure obtained after forming the first tunnel material layer, the first passivation contact material layer, and the first medium layer in the method for preparing the solar cell according to yet another embodiment of the present application.
FIG. 36 is a schematic sectional partial view of the solar cell according to an embodiment of the present application.
FIG. 37 is a schematic view showing a passivation contact region and a passivation region in the solar cell of FIG. 36.
FIG. 38 is a schematic sectional partial view of the solar cell according to another embodiment of the present application.
FIG. 39 is a schematic sectional partial view of the solar cell according to yet another embodiment of the present application.
FIG. 40 is a schematic sectional partial view of the solar cell according to yet another embodiment of the present application.
FIG. 41 is a partial view of the solar cell of FIG. 40.

### Reference signs:

1, solar cell; 11, semiconductor substrate; 11a, first surface; 11b, second surface; 11b1, passivation contact region; 11b2, passivation region; 11c, third surface; 11d, first diffusion region; 11e, second diffusion region; 12, first tunneling passivation structure; 121, first tunnel layer; 122, first passivation contact layer; 13, second tunneling passivation structure; 131, second tunnel layer; 132, second passivation contact layer; 1321, first passivation contact sub-layer; 1322, barrier layer; 1323, second passivation contact sub-layer; 14, first passivation layer; 15, second passivation layer; 16, first anti-reflective layer; 17, second anti-reflective layer; 18, first electrode; 19, second electrode; 110, third tunnel layer; 111, third passivation layer;
21, first tunnel material layer; 22, first passivation contact material layer; 23, first medium layer; 24, second tunnel material layer; 25, second passivation contact material layer; 251, first passivation contact material sub-layer; 252, barrier material layer; 253, second passivation contact material sub-layer; 26, second medium layer; 27, mask layer; 28, heat treatment by-product.

### DETAILED DESCRIPTION

The present application is described herein in detail with reference to the accompanying drawings in order to make the objects, features, and advantages of the present application clearer. In the following description, many specific details are explained to make the present application fully understandable. However, the present application can be implemented in many other ways different from those described herein, and those skilled in the art can make similar improvements without departing from the connotation of the present application. Therefore, the present application is not limited by the specific embodiments disclosed below.

Unless defined otherwise, all technical and scientific terms used herein have the same meaning as commonly understood by those skilled in the art of the present application. The terms used in the specification of the present application are for the purpose of describing exemplary examples only and are not intended to limit the present application.

It should be understood that when an element or a layer is referred to as being "on", "adjacent to", "connected to", or "coupled to" another element or layer, it can be directly on, adjacent to, connected to, or coupled to another element or layer, or an intermediate element or layer can be present. In contrast, when an element is referred to as being "directly on", "directly adjacent to", "directly connected to", or "directly coupled to" another element or layer, there is no intervening element or layer. It can be understood that although the terms first, second, third etc. may be used to describe various elements, components, regions, layers, sections, and/or doping types, these elements, components, regions, layers, sections, and/or doping types should not be limited by these terms. These terms are only used to distinguish one element, component, region, layer, section, and/or doping type from another element, component, region, layer, section, and/or doping type respectively. Thus, a first element, component, region, layer, section, and/or doping type described below can be termed as a second element, component, region, layer, section, and/or doping type respectively without departing from the teachings of the present application.

For the convenience of description, the spatial relation terms such as "below", "under", "beneath", "above", "on", "over", etc., may be used herein to describe the relationships of an element or a feature with other elements or features shown in the drawings. It should be understood that the terms of spatial relations are intended to include other different orientations in use or operation in addition to the orientation of the elements or features shown in the drawings. For example, if the device in a drawing is placed upside down, the element or feature which was "above" or "over" other elements or features will be "below" or "under" other elements or features. Thus, the exemplary terms "below" and "beneath" may cover the meanings of "above" or "below". The element or feature can also be positioned in other different ways (e.g., rotating 90 degrees or at other orientations), and the spatial relation terms used herein can be correspondingly interpreted.

As used herein, the singular forms with "a", "an", "the", or "said" are intended to include the plural forms as well, unless the context clearly indicates otherwise. It should also be understood that the terms "consists of" and/or "comprising", when used in the present application, identify the presence of the stated features, integers, steps, operations, elements and/or parts, but do not exclude presence or addition of one or more other features, integers, steps, operations, elements, parts and/or groups. As used herein, the term "and/or" means that any one of the listed items can be employed by itself or any combination of two or more of the listed items can be employed.

The embodiments of the present application are described herein with reference to cross-sectional views of idealized embodiments (and intermediate structures) of the present application. It can be expected that some variations of the shown shapes may exist due to, for example, manufacturing techniques and/or engineering tolerances. Thus, embodiments of the present application should not be limited to the particular shapes of the regions shown herein but include deviations in shapes due to, for example, manufacturing. The regions shown in the drawings are schematic substantially, and their shapes are not intended to be the actual shapes of the regions of the device or limit the scope of the present application.

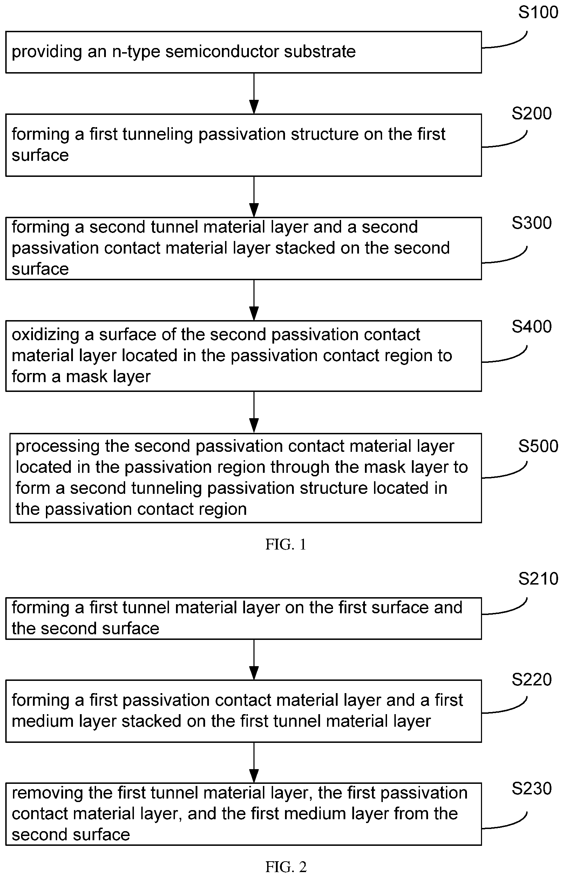

Referring to FIGs. 1 to 35, according to embodiments of the present application, a method for preparing a solar cell includes steps S100 to S500.

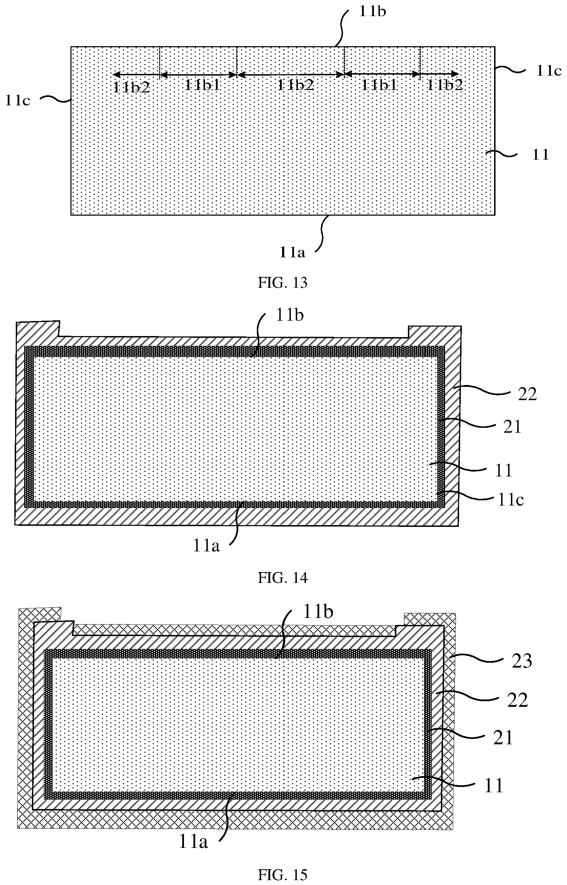

S100: providing an n-type semiconductor substrate 11. Referring to FIG. 13, the semiconductor substrate 11 includes a first surface 11a and a second surface 11b opposite to each other. The semiconductor substrate 11 can further include a third surface 11c connecting the first surface 11a and the second surface 11b. The second surface 11b includes a passivation contact region 11b1 and a passivation region 11b2 adjacent to each other. In some embodiments, the semiconductor substrate 11 is made of silicon. In some embodiments, the first surface 11a corresponds to the back face of the solar cell 1, which is away from the sun in operation of the solar cell, the second surface 11b corresponds to the front face of the solar cell 1, which faces the sun in operation of the solar cell, and the third surface 11c corresponds to a side edge of the solar cell 1.

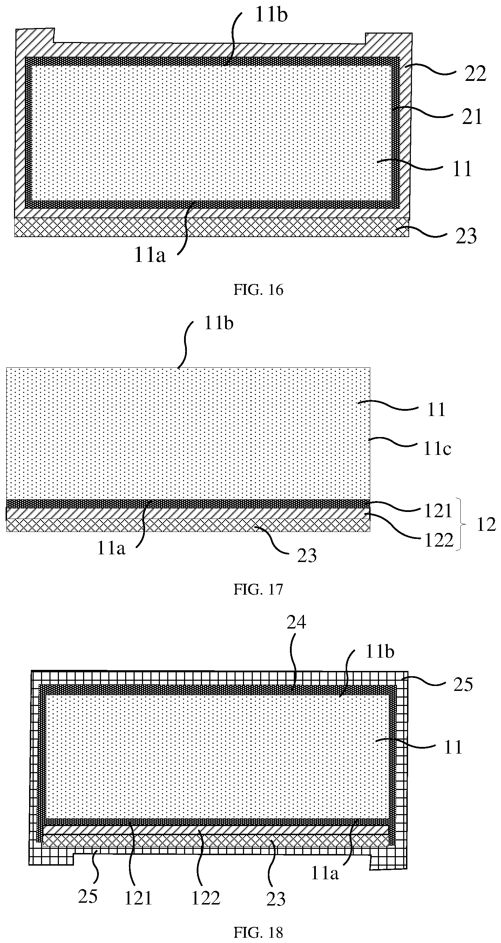

S200: forming a first tunneling passivation structure 12 on the first surface 11a. An embodiment of the structure obtained after forming the first tunneling passivation structure 12 is shown in FIG. 17. The first tunneling passivation structure 12 includes a first tunnel layer 121 and a first passivation contact layer 122, which are stacked in a direction away from the semiconductor substrate 11. The doping type of the first passivation contact layer 122 is p-type. In some embodiments, the semiconductor substrate 11 can be polished before step S200.

S300: forming a second tunnel material layer 24 and a second passivation contact material layer 25 stacked on the second surface 11b. An embodiment of the structure obtained after forming the second tunnel material layer 24 and the second passivation contact material layer 25 is shown in FIG. 18. The second tunnel material layer 24 can be made of a dielectric material, such as silicon oxide, aluminum oxide, silicon nitride, silicon oxynitride, magnesium fluoride, amorphous silicon, polysilicon, silicon carbide, or titanium oxide. The second passivation contact material layer 25 can be made of polysilicon doped with an n-type dopant. The second tunnel material layer 24 and the second passivation contact material layer 25 can be formed by the methods such as atomic layer deposition (ALD), plasma enhanced chemical vapor deposition (PECVD), plasma enhanced atomic layer deposition (PEALD), low pressure chemical vapor deposition (LPCVD), etc.

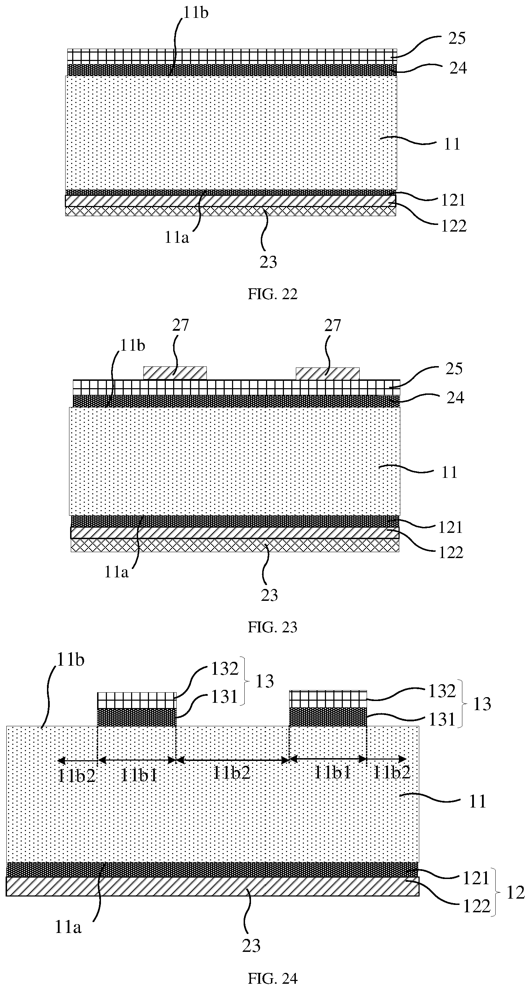

S400: oxidizing a surface of the second passivation contact material layer 25 located in the passivation contact region 11b1 to form a mask layer 27. The structure obtained after forming the mask layer 27 is shown in FIG. 23. Specifically, the surface of the second passivation contact material layer 25 can be oxidized to generate silicon oxide on the second passivation contact material layer 25, thereby forming the mask layer 27.

S500: processing the second passivation contact material layer 25 located in the passivation region 11b2 through the mask layer 27 to form a second tunneling passivation structure 13 located in the passivation contact region 11b1. Referring to FIG. 24, the second tunneling passivation structure 13 includes a second tunnel layer 131 and a second passivation contact layer 132, and the doping type of the second passivation contact layer 132 is n-type. It can be understood that in step S500, only the second passivation contact material layer 25 can be processed located in the passivation region 11b2, or both the second tunnel material layer 24 and the second passivation contact material layer 25 located in the passivation region 11b2 can be processed. Specifically, the second passivation contact material layer 25 located beyond the passivation contact region 11b1 can be processed with an alkaline solution.

In the embodiments of the present application, the second surface 11b can be divided into the passivation contact region 11b1 and the passivation region 11b2 according to whether there is the second tunneling passivation structure 13 disposed thereon or not. In other words, the passivation contact region 11b1 can be defined as the region of the second surface 11b where the second tunneling passivation structure 13 is disposed, while the passivation region 11b2 can be defined as the region of the second surface 11b where no second tunneling passivation structure 13 is disposed. The solar cell can include one or more second tunneling passivation structures 13, and correspondingly, the second surface 11b can be divided into one or more passivation contact regions 11b1 and one or more passivation regions 11b2. The second tunneling passivation structures 13 can be spaced from each other. The passivation contact regions 11b1 and the passivation regions 11b2 can be alternately arranged along a direction parallel to the second surface 11b.

In the method for preparing the solar cell provided by the embodiments of the present application, on the one hand, the first and second tunneling passivation structures 12 and 13 formed respectively on the opposite sides of the solar cell as a bifacial tunneling passivation structure can effectively improve the efficiency of the solar cell. On the other hand, by oxidizing the surface of the second passivation contact material layer 25 located in the passivation contact region 11b1, the mask layer 27 can be formed on the second passivation contact material layer 25 located in the passivation contact region 11b1. The second passivation contact material layer 25 located in the passivation region 11b2 can be processed through the mask layer 25, thereby reducing the manufacturing cost of the solar cell 1 compared with the method of forming a mask layer by large-area laser etching a borosilicate glass or phosphosilicate glass layer in the related art.

In some embodiments, step S400, oxidizing the surface of the second passivation contact material layer 25 located in the passivation contact region 11b1 to form the mask layer 27, includes the following step S410.

S410: laser oxidizing the surface of the second passivation contact material layer 25 located in the passivation contact region 11b1 to form the mask layer 27. As such, the second passivation contact material layer 25 can be conveniently and locally oxidized by laser, thereby forming the mask layer 27 on the second passivation contact material layer 25 located in the passivation contact region 11b1 through the oxidation. Specifically, by using a laser beam to scan the surface of a local area of the second passivation contact material layer 25, the laser scanned surface of the second passivation contact material layer 25 can be oxidized to form an oxide layer as the mask layer 27. The local area scanned by laser can be in alignment with the passivation contact region 11b1, thereby forming the mask layer 27 covering the entire passivation contact region 11b1 and only covering the passivation contact region 11b1. In some embodiments, the material of the second passivation contact material layer 25 is silicon, and thus the material of the formed mask layer 27 is a silicon oxide. It can be understood that as only a surface layer of the second passivation contact material layer 25 is oxidized, there is still the second passivation contact material layer 25, which may be thinned, under the mask layer 27 corresponding to the passivation contact region 11b1.

In some embodiments, an ultraviolet picosecond laser can be adopted for the oxidation. Furthermore, the laser power can be in a range from 20W to 40W. For example, the laser power can be 20W, 25W, 30W, 40W, or any value therebetween. Additionally, the laser beam can form a spot in a square shape, and each side of the square spot can be smaller than 40µm.

The laser with the above parameters can reduce damage to the semiconductor substrate 11 caused by the laser, ensuring the efficiency of the solar cell 1 while allowing the formation of a uniform mask layer 27 on the surface of the second passivation contact material layer 25.

In some embodiments, after step S200 and before step S300, the method further includes step S250.

S250: texturing the semiconductor substrate 11 to form pyramidal textured structures in the second surface 11b.

In the related art of forming the second tunneling passivation structure 13, a layer of borosilicate glass (BSG) or phosphosilicate glass (PSG) may be previously formed on the entire second passivation contact material layer 25, and then the BSG or PSG layer can be laser etched to form the mask layer. However, as the passivation region 11b2 is typically much larger than the passivation contact region 11b1, a large area of the BSG or PSG layer needs to be etched in order to remove the area of the BSG or PSG layer corresponding to the passivation region 11b2 and retaining only the area of the BSG or PSG layer corresponding to the passivation contact region 11b1. In addition, the energy of the laser etching may be relatively high, which may cause damage on the surface area of the semiconductor substrate 11 corresponding to the laser etched area of the BSG or PSG layer. Thus, in the following step of forming the second tunneling passivation structure 13 through the mask layer, the semiconductor substrate 11 may need to be wet etched to remove the damaged surface area of the semiconductor substrate 11, during which the pyramidal textured structures in the passivation region 11b2 may be destructed. As a result, an additional texturing step is required to recreate new pyramidal textured structures in the passivation region 11b2. Due to the parameter differences between the two texturing steps, the pyramidal textured structures in the passivation contact region 11b1 and in the passivation region 11b2 are inconsistent with each other, resulting in a reflectivity difference ranged from 1% to 2% between the passivation contact region 11b1 and the passivation region 11b2.

In contrast, in the embodiments of the present application, the mask layer 27 is formed from oxidizing the surface of the area of the second passivation contact material layer 25 located in the passivation contact region 11b1. Although the oxidization can be achieved by laser scanning, the laser is only applied onto the local area corresponding to the passivation contact region 11b1, which is much smaller than the passivation region 11b2, and the energy of the laser scanning is relatively mild, preventing or reducing the damage to the corresponding area of the semiconductor substrate 11. Thus, in the method provided by the embodiments of the present application, the second surface 11b can be subjected to only one texturing step, i.e., step S250. The semiconductor substrate 11 does not need to be wet etched in the following step of forming the second tunneling passivation structure 13. As a result, the reflectivity difference between the passivation contact region 11b1 and the passivation region 11b2 can be reduced in the prepared solar cell product.

In some embodiments, referring to FIG. 2 and FIGs. 14 to 17, step S200, forming the first tunneling passivation structure 12 on the first surface 11a, specifically includes steps S210 to S230.

S210, forming a first tunnel material layer 21 on the first surface 11a and the second surface 11b. For example, the first tunnel material layer 21 can be formed through a plasma oxidation method or a thermal oxidation method. Referring to FIG. 14, in S210, the first tunnel material layer 21 can also be simultaneously formed on the third surface 11c, or further entirely wrap the semiconductor substrate 11. The first tunnel material layer 21 can be made of a dielectric material, such as silicon oxide, aluminum oxide, silicon nitride, silicon oxynitride, magnesium fluoride, amorphous silicon, polysilicon, silicon carbide, or titanium oxide.

S220: forming a first passivation contact material layer 22 and a first medium layer 23 stacked on the first tunnel material layer 21. For example, referring to FIGs. 14 and 15, the first passivation contact material layer 22 can be formed by the methods such as PECVD, LPCVD, etc. The first passivation contact material layer 22 can be made of polysilicon doped with a p-type dopant or without any dopant.

S230: removing the first tunnel material layer 21, the first passivation contact material layer 22, and the first medium layer 23 from the second surface 11b. Specifically, these layers can be removed by using a wet etching method. Referring to FIGs. 16 and 17, the first tunnel material layer 21, the first passivation contact material layer 22, and the first medium layer 23 can also be simultaneously removed from the third surface 11c in S230, leaving only the first surface 11a, covered by these layers.

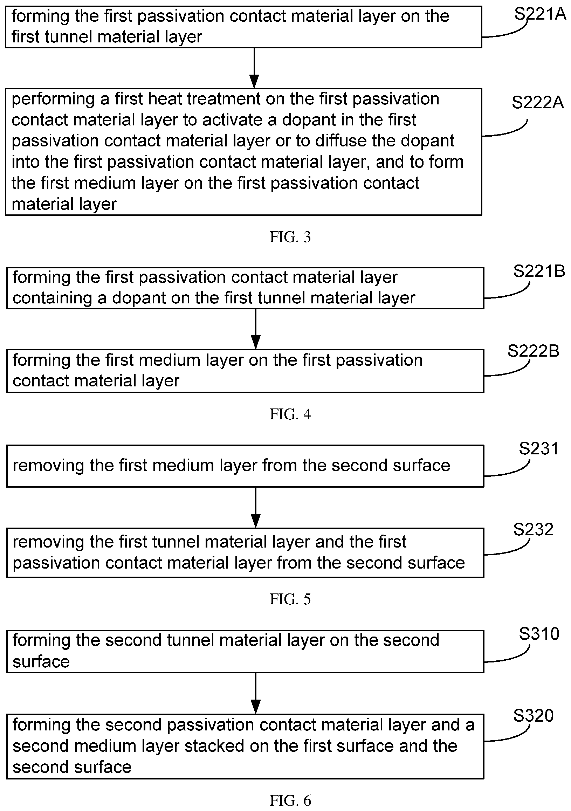

In some embodiments, referring to FIG. 3, step S220, forming the first passivation contact material layer 22 and the first medium layer 23 stacked on the first tunnel material layer 21, specifically includes steps S221A and S222A.

S221A: forming the first passivation contact material layer 22 on the first tunnel material layer 21. Referring to FIG. 14, the first passivation contact material layer 22 can be formed by LPCVD. The first passivation contact material layer 22 can be doped with a p-type dopant, such as a boron element, or without any dopant.

S222A, performing a first heat treatment on the first passivation contact material layer 22 to activate the dopant in the first passivation contact material layer 22 or to diffuse the dopant into the first passivation contact material layer 22, and to form the first medium layer 23 on the first passivation contact material layer 22. It can be understood that the entire structure including the semiconductor substrate 11 and the layers 21 and 22 on the substrate 11 is subjected to the first heat treatment. In some embodiments, the first medium layer 23 can be made of borosilicate glass (BSG). The first heat treatment can be carried out in an oxygen containing atmosphere. In some embodiments, the temperature of the first heat treatment can be in a range from 900°C to 980°C.

Specifically, when the first passivation contact material layer 22 includes the dopant, the dopant can be activated during the first heat treatment, while the first medium layer 23 can be formed from the oxidation of the surface layer of the first passivation contact material layer 22 at the high temperature during the first heat treatment. For example, borosilicate glass as the first medium layer 23 can be formed from oxidation of boron doped polysilicon as the first passivation contact material layer 22. When the first passivation contact material layer 22 does not include any dopant, the dopant may be introduced into the first passivation contact material layer 22 from the external environment during the first heat treatment, e.g., through boron diffusion, while the first medium layer 23 can be formed during the first heat treatment. For performing the boron diffusion, a diffusion source layer can be formed on the first passivation contact material layer 22, or the first heat treatment can be carried out in an atmosphere containing both oxygen and a dopant source gas.

In some embodiments, referring to FIG. 4, step S220, forming the first passivation contact material layer 22 and the first medium layer 23 stacked on the first tunnel material layer 21, specifically includes S221B and S222B.

S221B: forming the first passivation contact material layer 22 containing the p-type dopant on the first tunnel material layer 21. For example, the first passivation contact material layer 22 containing a boron element as the p-type dopant can be formed by PECVD, that is, the first passivation contact material layer 22 is formed through in-situ doping.

S222B: forming the first medium layer 23 on the first passivation contact material layer 22. The first medium layer 23 can be formed simultaneously with step S221B.

It can be noted that the dopant in the first passivation contact material layer 22 can be further activated by a heat treatment, during which the first medium layer 23 can form a protection on the first passivation contact material layer 22.

In some embodiments, referring to FIG. 5, step S230, removing the first tunnel material layer 21, the first passivation contact material layer 22, and the first medium layer 23 from the second surface 11b, specifically includes steps S231 and S323.

S231: removing the first medium layer 23 from the second surface 11b. Specifically, the first medium layer 23 on the second surface 11b and the third surface 11c can be removed simultaneously by washing with a hydrofluoric acid solution, while the first medium layer 23 on the first surface 11a can be retained.

S232: removing the first tunnel material layer 21 and the first passivation contact material layer 22 from the second surface 11b. Specifically, the first tunnel material layer 21 and the first passivation contact material layer 22 on the second surface 11b and the third surface 11c can be removed simultaneously by polishing with an alkaline solution containing sodium hydroxide, while the first tunnel material layer 21 and the first passivation contact material layer 22 on the first surface 11a can be retained under the protection of the first medium layer 23 on the first surface 11a.

In some embodiments, referring to FIG. 6 and FIGs. 18 and 19, step S300, forming the second tunnel material layer 24 and the second passivation contact material layer 25 stacked on the second surface 11b, specifically includes steps S310 and S320.

S310: forming the second tunnel material layer 24 on the second surface 11b. For example, the second tunnel material layer 24 can be formed through a plasma oxidation method or a thermal oxidation method. It can be understood that the second tunnel material layer 24 can be simultaneously formed on the third surface 11c. In some embodiments, the second tunnel material layer 24 can be made of silicon oxide, and the exposed second and the third surfaces 11b, 11c of the semiconductor substrate 11 can be oxidized into a silicon oxide layer as the second tunnel material layer 24 through the plasma oxidation method or the thermal oxidation method. On the other hand, the first surface 11a of the semiconductor substrate 11 is covered by the first medium layer 23, and thus is not oxidized, avoiding the formation of the second tunnel material layer 24 on the first surface 11a. In some other embodiments, when the second tunnel material layer 24 is formed on the first surface 11a, it can be removed through an additional step.

S320: forming the second passivation contact material layer 25 and a second medium layer 26 stacked on the first surface 11a and the second surface 11b. For example, the second passivation contact material layer 25 can be formed by the methods such as PECVD, LPCVD, etc. It should be understood that the second passivation contact material layer 25 and the second medium layer 26 can also be formed on the third surface 11c, e.g., or further entirely wrap the semiconductor substrate 11.

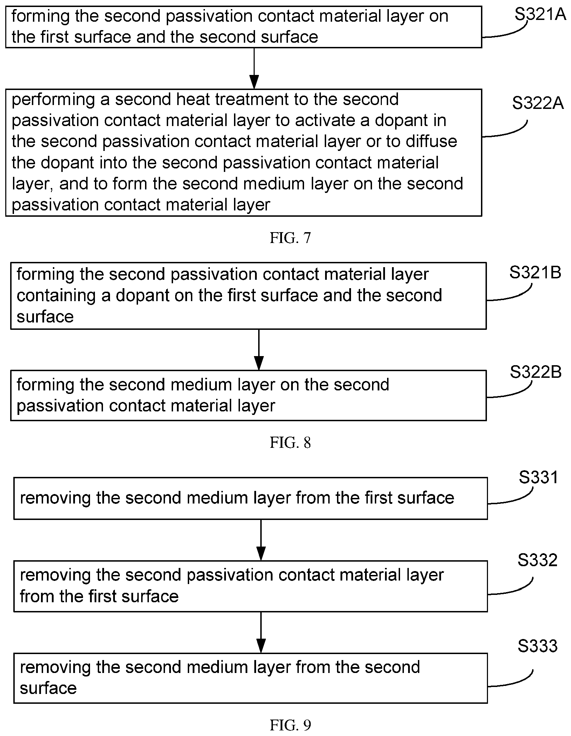

In some embodiments, referring to FIG. 7, step S320, forming the second passivation contact material layer 25 and the second medium layer 26 stacked on the first surface 11a and the second surface 11b, specifically includes steps S321A and S322A.

S321A: forming the second passivation contact material layer 25 on the first surface 11a and the second surface 11b. Specifically, the second passivation contact material layer 25 can be deposited by using LPCVD. The second passivation contact material layer 25 can be doped with an n-type dopant, such as a phosphorus element, or without any dopant. In some embodiments, the second passivation contact material layer 25 is formed on the first surface 11a, the second surface 11b, and the third surface 11c.

S322A: performing a second thermal treatment on the second passivation contact material layer 25 to activate the dopant in the second passivation contact material layer 25 or to diffuse the dopant into the second passivation contact material layer 25, and to form the second medium layer 26 on the second passivation contact material layer 25. The entire structure including the semiconductor substrate 11 and all the layers thereon is subjected to the second heat treatment. In some embodiments, the second medium layer 26 can be made of phosphosilicate glass (PSG). The second heat treatment can be carried out in an oxygen containing atmosphere. In some embodiments, the temperature of the second heat treatment can be in a range from 850°C to 930°C.

Specifically, when the second passivation contact material layer 25 includes the dopant, the dopant can be activated during the second heat treatment, while the second medium layer 26 can be formed from the oxidation of the surface layer of the second passivation contact material layer 25 at the high temperature during the second heat treatment. For example, phosphosilicate glass as the second medium layer 26 can be formed from oxidation of phosphorus doped polysilicon as the second passivation contact material layer 25. When the second passivation contact material layer 25 does not include any dopant, the dopant may be introduced into the second passivation contact material layer 25 from the external environment during the second heat treatment, e.g., through phosphorus diffusion, while the second medium layer 26 can be formed during the second heat treatment. For performing the phosphorus diffusion, a diffusion source layer can be formed on the second passivation contact material layer 25, or the second heat treatment can be carried out in an atmosphere containing both oxygen and a dopant source gas.

In some embodiments, referring to FIG. 8, step S320, forming the second passivation contact material layer 25 and the second medium layer 26 stacked on the first surface 11a and the second surface 11b, specifically includes S321B and S322B.

S321B: forming the second passivation contact material layer 25 containing an n-type dopant on the first surface 11a and the second surface 11b. For example, the second passivation contact material layer 25 doped with phosphorus elements as the n-type dopant can be formed by PECVD. In some embodiments, the second passivation contact material layer 25 also can be formed on the third surface 11c, simultaneously.

S322B: forming the second medium layer 26 on the second passivation contact material layer 25. The second medium layer 26 can be formed simultaneously with step S321B.

It can be noted that the dopant in the second passivation contact material layer 25 can be further activated by a heat treatment, during which the second medium layer 26 can form a protection on the second passivation contact material layer 25.

In some embodiments, after step S320, forming the second passivation contact material layer 25 and the second medium layer 26 stacked on the first surface 11a and the second surface 11b, the method further includes step S330A.

S330A, removing the second medium layer 26 and removing the second passivation contact material layer 25 from the first surface 11a. In some embodiments, the second passivation contact material layer 25 and the second tunnel material layer 24 on the third surface 11c can be simultaneously removed with the second passivation contact material layer 25 on the first surface 11a.

In some embodiments, referring to FIG. 9, S330A, removing the second medium layer 26 and removing the second passivation contact material layer 25 from the first surface 11a, includes steps S331 to S333.

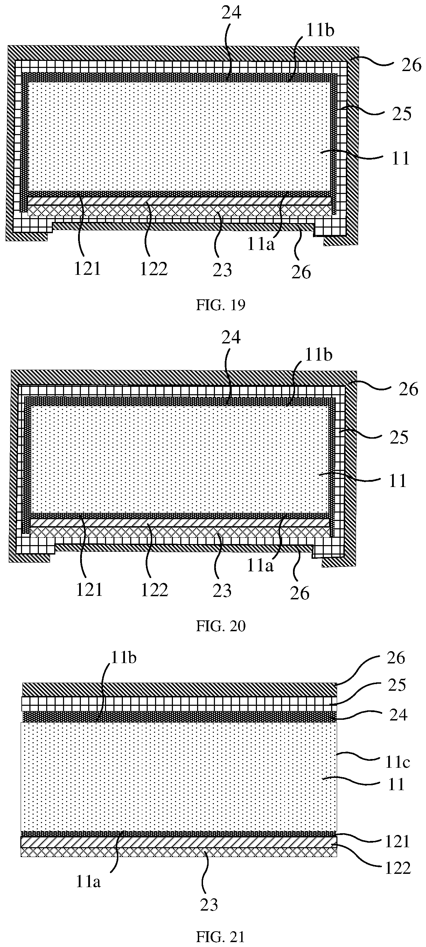

S331: removing the second medium layer 26 from the first surface 11a. Referring to FIGs. 19 and 20, the layers on the semiconductor substrate 11 can be locally etched with a hydrofluoric acid solution, thereby removing the second medium layer 26 from the first surface 11a, and optionally from the third surface 11c, while retaining the second medium layer 26 on the second surface 11b.

S332: removing the second passivation contact material layer 25 from the first surface 11a. In some embodiments, the second passivation contact material layer 25 and the second tunnel material layer 24 on the third surface 11c can be simultaneously removed with the second passivation contact material layer 25 on the first surface 11a, while the second passivation contact material layer 25 and the second tunnel material layer 24 on the second surface 11b can be retained. Referring to FIG. 21, the layers on the first and third surfaces 11a, 11c can be etched with an alkaline solution containing potassium hydroxide and removed, while the layers on the second surface 11b can be protected by the second medium layer 26 on the second surface 11b and retained.

S333: removing the second medium layer 26 from the second surface 11b. Referring to FIG. 22, the second medium layer 26 can be removed by etching with the hydrofluoric acid solution.

In some embodiments, S500, processing the second passivation contact material layer 25 located in the passivation region 11b2 through the mask layer 27 to form the second tunneling passivation structure 13 located in the passivation contact region 11b1, specifically includes step S510.

S510: removing the second tunnel material layer 24 and the second passivation contact material layer 25 located in the passivation region 11b2 through the mask layer 27 to form the second tunneling passivation structure 13 located in the passivation contact region 11b1.

Specifically, referring to FIGs. 23 and 24, after the mask layer 27 is formed, the second tunnel material layer 24 and the second passivation contact material layer 25 on the passivation region 11b2 can be removed using an alkaline solution and an acid solution. Specifically, the second passivation contact material layer 25 can be removed by etching with the alkaline solution, and the second tunnel material layer 24 and the mask layer 27 can be removed by etching with the acid solution.

In some embodiments, the alkaline solution includes sodium hydroxide, and the acidic solution includes hydrofluoric acid.

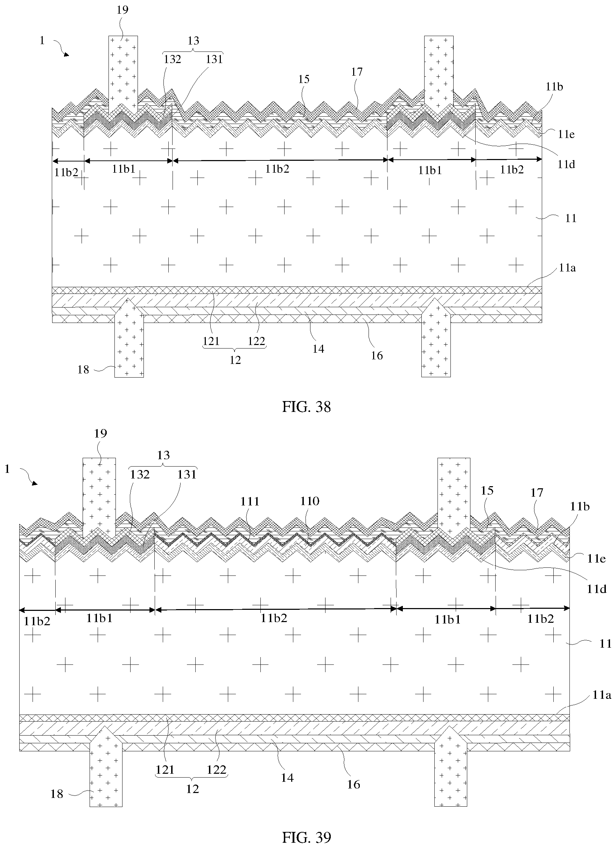

In some embodiments, referring to FIG. 38, a first diffusion region 11d is formed in the semiconductor substrate 11 and is adjacent to the second surface 11b and corresponding to the passivation contact region 11b1, and a second diffusion region 11e is formed in the semiconductor substrate 11 and is adjacent to the second surface 11b and corresponding to the passivation area 11b2. The first diffusion region 11d and the second diffusion region 11e, which are formed by the dopant locally diffusing into the semiconductor substrate 11, are regions with a doping concentration different from the other area of the semiconductor substrate 11. In some embodiments, in the second heat treatment, the n-type dopant may be diffused into the local area of the n-type semiconductor substrate 11 adjacent to the second surface 11b from the second passivation contact material layer 25, such that the doping concentration of the first diffusion region 11d and the second diffusion region 11e is greater than the doping concentration of the other area of the semiconductor substrate 11. During the removal of the second tunnel material layer 24 and the second passivation contact material layer 25 located in the passivation area 11b2, the second diffusion region 11e can be removed or retained.

In some embodiments, during the removal of the second tunnel material layer 24 located in the passivation area 11b2, the etching can be terminated at the second surface 11b of the semiconductor substrate 11 so as to retain the second diffusion region 11e.

In some other embodiments, when the second tunnel material layer 24 is etched, the semiconductor substrate 11 can be further etched by a certain depth from the exposed passivation area 11b2 of the second surface 11b, so as to remove the second diffusion region 11e. Specifically, a wet etching solution containing 1% to 2% potassium hydroxide can be adopted. The etching depth in the semiconductor substrate 11 can be controlled by controlling the etching temperature in a range from 40°C to 60°C and the etching time in a range from 120 seconds to 250 seconds, thereby uniformly removing the second diffusion region 11e from the semiconductor substrate 11.

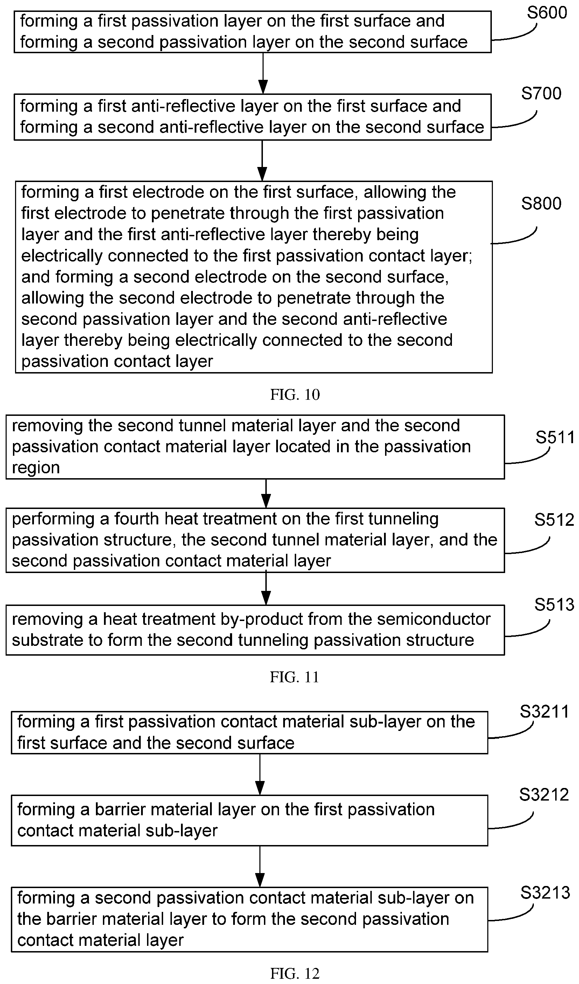

In some embodiments, referring to FIG. 10 and FIGs. 24 to 27, after S500, processing the second passivation contact material layer 25 located in the passivation region 11b2 through the mask layer 27 to form the second tunneling passivation structure 13 located in the passivation contact region 11b1, the method further includes steps S600 to S800.

S600: forming a first passivation layer 14 on the first surface 11a and forming a second passivation layer 15 on the second surface 11b. The first passivation layer 14 and the second passivation layer 15 both can be made of aluminum oxide.

S700: forming a first anti-reflective layer 16 on the first surface 11a and forming a second anti-reflective layer 17 on the second surface 11b. The first anti-reflective layer 16 and the second anti-reflective layer 17 both can be made of silicon nitride.

S800: forming a first electrode 18 on the first surface 11a, allowing the first electrode 18 to penetrate through the first passivation layer 14 and the first anti-reflective layer 16 thereby being electrically connected to the first passivation contact layer 122; and forming a second electrode 19 on the second surface 11b, allowing the second electrode 19 to penetrate through the second passivation layer 15 and the second anti-reflective layer 17 thereby being electrically connected to the second passivation contact layer 132.

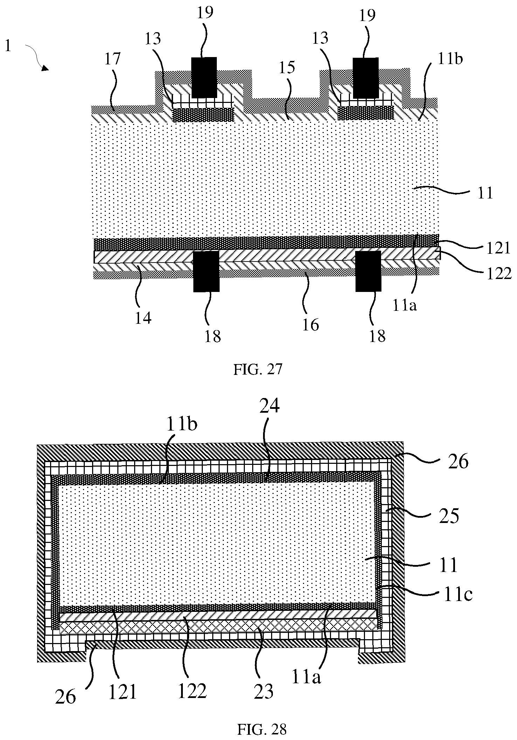

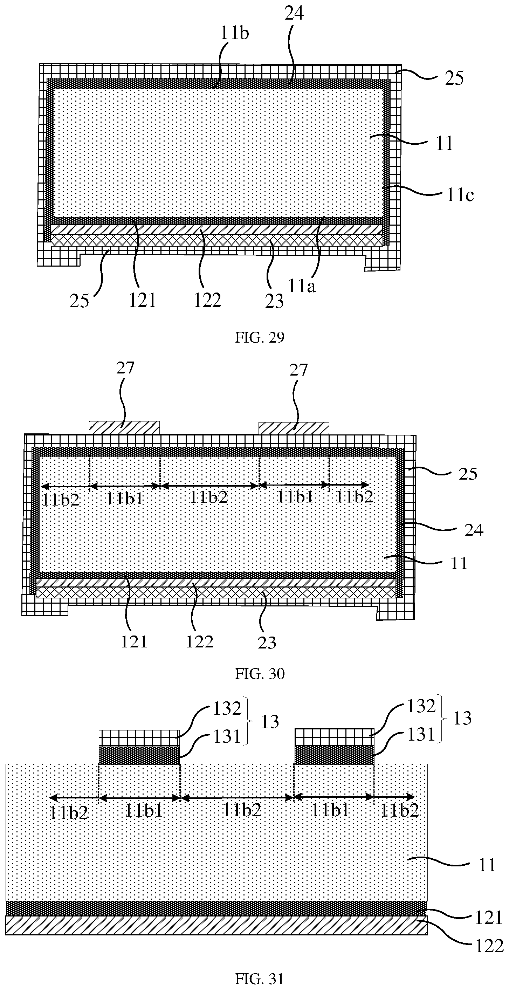

In some embodiments, referring to FIGs. 28 and 29, after S320, forming the second passivation contact material layer 25 and the second medium layer 26 stacked on the first surface 11a and the second surface 11b, the method further includes step S330B.

S330B: removing the second medium layer 26. Specifically, the second medium layer 26 can be etched with a hydrofluoric acid solution, thereby being entirely removed from the first surface 11a, the second surface 11b, and the third surface 11c.

In some embodiments, referring to FIG. 11 and FIGs. 30 to 33, S510, removing the second tunnel material layer 24 and the second passivation contact material layer 25 located in the passivation region 11b2 through the mask layer 27 to form the second tunneling passivation structure 13 located in the passivation contact region 11b1, specifically includes steps S511 to S513.

S511: removing the second tunnel material layer 24 and the second passivation contact material layer 25 located in the passivation region 11b2. Referring to FIGs. 30 and 31, the second passivation contact material layer 25 on the third surface 11c, the first surface 11a, and the passivation region 11b2, as well as the second tunnel material layer 24 on the third surface 11c and the passivation region 11b2, can be removed. Specifically, the second passivation contact material layer 25 can be removed by using an alkaline solution, and the second tunnel material layer 24 and the mask layer 27 can be removed by using an acid solution.

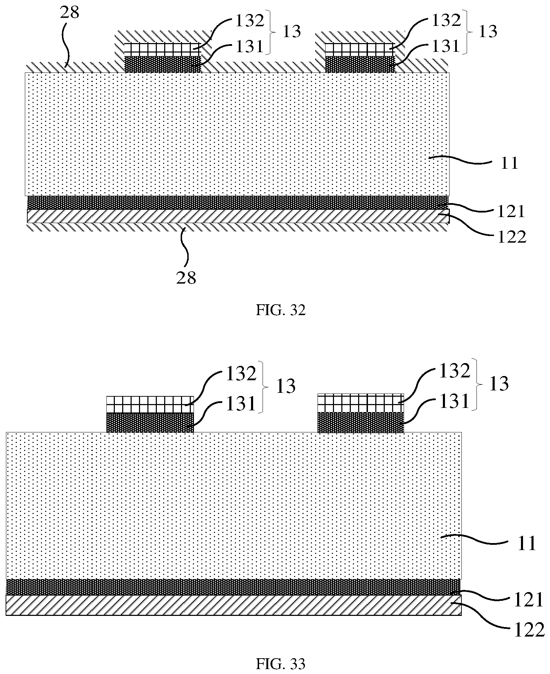

S512: performing a fourth heat treatment on the first tunneling passivation structure 12, the second tunnel material layer 24, and the second passivation contact material layer 25, thereby forming the second tunnel material layer 24, and the second passivation contact material layer 25 located in the passivation contact region 11b1 into the second tunnel layer 131 and the second passivation contact layer 132. In this step, on the one hand, the first passivation contact layer 122 and/or the second passivation contact layer 132 can be crystallized; on the other hand, the dopants within the first passivation contact layer 122 and/or the second passivation contact layer 132 can be activated. In some embodiments, the fourth heat treatment can be carried out in an oxygen containing atmosphere. Referring to FIG. 32, a heat treatment by-product 28, such as a silicon oxide, can be formed on the exposed surface of the semiconductor substrate 11, the first passivation contact layer 122 and/or the second passivation contact layer 132 during the fourth heat treatment.

S513: removing the heat treatment by-product 28 from the semiconductor substrate 11 to form the second tunneling passivation structure 13. Specifically, referring to FIG. 33, the thermal treatment by-products 28 can be removed by using a hydrofluoric acid solution.

In some embodiments, referring to FIG. 39, S500, processing the second passivation contact material layer 25 located in the passivation region 11b2 through the mask layer 27 to form the second tunneling passivation structure 13 located in the passivation contact region 11b1, specifically includes step S520.

S520: thinning the second passivation contact material layer 25 located in the passivation region 11b2 through the mask layer 27 to form the second tunneling passivation structure 13 located in the passivation contact region 11b1, and forming a third tunnel layer 110 and a third passivation layer 111 stacked in the passivation region 11b2. The third passivation layer 111 is formed from the thinned second passivation contact material layer 25 located in the passivation region 11b2. The third passivation layer 111 and the second passivation contact layer 132 can be made of the same material. The third passivation layer 111 can be thinner than the second passivation contact layer 132.

By forming the third tunneling layer 110 and the third passivation layer 111 stacked in the passivation region 11b2, the passivation effect of the solar cell 1 can be improved, and the passivation interface is more stable. In UV testing of the solar cell, this configuration can reduce the degradation of the solar cell 1. The third passivation layer 111, which is formed from thinning the second passivation contact material layer 25, is relatively thin, reducing the light absorption of third passivation layer 111 and thereby enhancing the efficiency of the solar cell 1.

Specifically, the second passivation contact material layer 25 can be wet etched with an alkaline solution containing such as potassium hydroxide.

In some embodiments, the concentration of potassium hydroxide in the alkaline solution is in a range from 1% to 2%, the etching temperature can be in a range from 40°C to 60°C, and the etching time can be in a range from 100 seconds to 200 seconds. The above parameters are beneficial to forming a uniform third passivation layer 111, thereby improving the passivation effect of the solar cell 1.

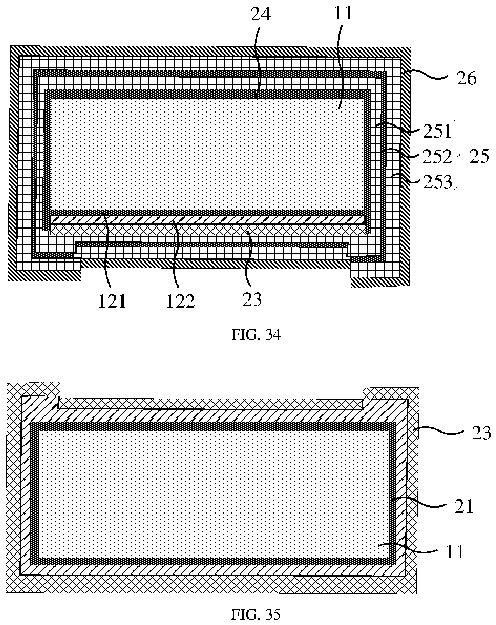

In some embodiments, referring to FIG. 12 and FIG. 34, S321B, forming the second passivation contact material layer 25 containing the n-type dopant on the first surface 11a and the second surface 11b, specifically includes steps S3211 to S3213.

S3211: forming a first passivation contact material sub-layer 251 on the first surface 11a and the second surface 11b. Specifically, the first passivation contact material sub-layer 251 can be formed by PECVD. In some embodiments, the first passivation contact material sub-layer 251 is simultaneously formed on the third surface 11c, or further entirely wraps the semiconductor substrate 11.

S3212: forming a barrier material layer 252 on the first passivation contact material sub-layer 251. The barrier material layer 252 can be made of silicon dioxide.

S3213: forming a second passivation contact material sub-layer 253 on the barrier material layer 252, so as to form the second passivation contact material layer 25. Specifically, the second passivation contact material sub-layer 253 can be formed by PECVD.

The first passivation contact material sub-layer 251, the barrier material layer 252, and the second passivation contact material sub-layer 253 together form the second passivation contact material layer 25. By arranging the barrier material layer 252, the wet etching of the second passivation contact material layer 25 can be conveniently terminated at the barrier material layer 252, preventing over etching of the second passivation contact material layer 25.

In some embodiments, after S320, forming the second passivation contact material layer 25 and the second medium layer 26 stacked on the first surface 11a and the second surface 11b, the method further includes step S3201.

S3201: performing a third heat treatment on the first tunneling passivation structure 12, the second tunnel material layer 24, and the second passivation contact material layer 25, thereby forming the second tunnel material layer 24 and the second passivation contact material layer 25 into the second tunnel layer 131 and the second passivation contact layer 132. In this step, on the one hand, the first passivation contact material layer 22 and/or the second passivation contact material layer 25 can be crystallized, and on the other hand, the dopants within the first passivation contact material layer 22 and/or within the second passivation contact material layer 25 can be activated. In some embodiments, the temperature of the third heat treatment can be in a range from 900°C to 930°C.

Based on the above embodiments, specific examples are proposed and described in detail below.

### Example 1

A method for preparing a solar cell includes the following steps.

An n-type semiconductor substrate 11 is provided. The semiconductor substrate 11 includes a first surface 11a and a second surface 11b opposite each other, and further includes a third surface 11c connecting the first surface 11a and the second surface 11b. The second surface 11b includes passivation contact regions 11b1 and passivation regions 11b2 alternately arranged and adjacent to each other.

The semiconductor substrate 11 is polished. The polished semiconductor substrate 11 is shown in FIG. 13.

A first tunnel material layer 21 is formed on the first surface 11a, the second surface 11b, and the third surface 11c.

A first passivation contact material layer 22 is formed on the first tunnel material layer 21 by LPCVD. The structure obtained after the formation of the first passivation contact material layer 22 and the first tunnel material layer 21 is shown in FIG. 14. During the deposition of the first passivation contact material layer 22, gas may flow from the back side (the first surface 11a) of the semiconductor substrate 11, passing by the side edges (the third surface 11c) and the front side (second surface 11b) of the semiconductor substrate 11. Thus, gas distribution at the second surface 11b of the semiconductor substrate 11 may not be so uniform that the thickness of the first passivation contact material layer 22 on the second surface 11b may be uneven and relatively small at the center of the second surface 11b.

The first passivation contact material layer 22 is subjected to a first heat treatment process to diffuse a p-type dopant into the first passivation contact material layer 22. For performing the dopant diffusion, a diffusion source layer can be formed on the first passivation contact material layer 22, or the first heat treatment can be carried out in an atmosphere containing a dopant source gas. During the first heat treatment process, the first passivation contact material layer 22 is oxidized, thereby forming the first medium layer 23 simultaneously on the first passivation contact material layer 22. In the present example, the dopant is a boron element. The structure obtained after the first heat treatment is shown in FIG. 15.

The semiconductor substrate 11 is washed with acid to remove the first medium layer 23 from the second surface 11b and the third surface 11c, while the first medium layer 23 on the first surface 11a is retained. Specifically, a hydrofluoric acid solution is used for acid washing. The structure obtained after acid washing is shown in FIG. 16.

The semiconductor substrate 11 is then polished to remove the first passivation contact material layer 22 and the first tunnel material layer 21 from the second surface 11b and the third surface 11c. Specifically, an alkaline solution containing sodium hydroxide is used for polishing. Under the protection of the first medium layer 23 on the first surface 11a, the first passivation contact material layer 22 and the first tunnel material layer 21 on the first surface 11a is retained. The polished structure is schematically shown in FIG. 17.

The polished semiconductor substrate 11 is textured to form pyramidal textured structures in the second surface 11b. It should be noted that the pyramidal textured structures are not shown in the schematic drawings for the preparation steps but can be referred to the schematic drawings for the solar cells.

A second tunnel material layer 24 is then formed on the second surface 11b and the third surface 11c of the semiconductor substrate 11.

After that, a second passivation contact material layer 25 is formed on the first surface 11a, the second surface 11b, and the third surface 11c by LPCVD. The structure obtained after forming the second tunnel material layer 24 and the second passivation contact material layer 25 is shown in FIG. 18. During the deposition of the second passivation contact material layer 25, gas may flow from the front side (the second surface 11b) of the semiconductor substrate 11, passing by the side edges (the third surface 11c) and the back side (the first surface 11a) of the semiconductor substrate 11. Thus, gas distribution at the first surface 11a of the semiconductor substrate 11 may not be so uniform that the thickness of the second passivation contact material layer 25 on the first surface 11a may be uneven and relatively small at the center of the second surface 11b.

The second passivation contact material layer 25 is subjected to a second heat treatment to diffuse an n-type dopant into the second passivation contact material layer 25. During the second heat treatment process, the surface of the second passivation contact material layer 25 is oxidized, thereby forming the second medium layer 26 simultaneously on the second passivation contact material layer 25. In the present example, the dopant is a phosphorus element. The structure obtained after the second heat treatment is shown in FIG. 19.

The semiconductor substrate 11 is washed with acid to remove the second medium layer 26 from the first surface 11a and the third surface 11c, while the second medium layer 26 on the second surface 11b is retained. Specifically, a hydrofluoric acid solution is used for acid washing. The structure obtained after acid washing is shown in FIG. 20.

The semiconductor substrate 11 is then polished to remove the second passivation contact material layer 25 from the first surface 11b and the third surface 11c and to remove the second tunnel material layer 24 from the third surface 11c. Specifically, an alkaline solution containing sodium hydroxide is used for polishing. Under the protection of the second medium layer 26 on the second surface 11b, the second passivation contact material layer 25 and the second tunnel material layer 24 on the second surface 11b is retained. The polished structure is schematically shown in FIG. 21.

After that, the semiconductor substrate 11 is washed with acid to remove the second medium layer 26 from the second surface 11b. Specifically, a hydrofluoric acid solution is used for acid washing. The structure obtained after acid washing is shown in FIG. 22.

The local areas of the surface of the second passivation contact material layer 25 are oxidized to form a mask layer 27. The local areas are in alignment with the passivation contact regions 11b1. Specifically, an ultraviolet picosecond laser is adopted to perform the oxidation. The structure obtained after the oxidation is shown in FIG. 23.

Through the mask layer 27, the second tunnel material layer 24 and the second passivation contact material layer 25 located in the passivation regions 11b2 are removed, thereby forming the second tunneling passivation structures 13. The first medium layer 23 can be simultaneously removed from the first surface 11a with the second tunnel material layer 24. Specifically, the second passivation contact material layer 25 is removed by using an alkaline solution containing potassium hydroxide, and the second tunnel material layer 24 is removed by using an acid solution containing hydrofluoric acid. The structure obtained after forming the second tunneling passivation structures 13 is shown in FIG. 24. Under the protection of the mask layer 27, the second tunnel material layers 24 and the second passivation contact material layers 25 on the second surface 11b and located in the passivation contact regions 11b1 can be retained, thereby forming the second tunneling passivation structures 13.

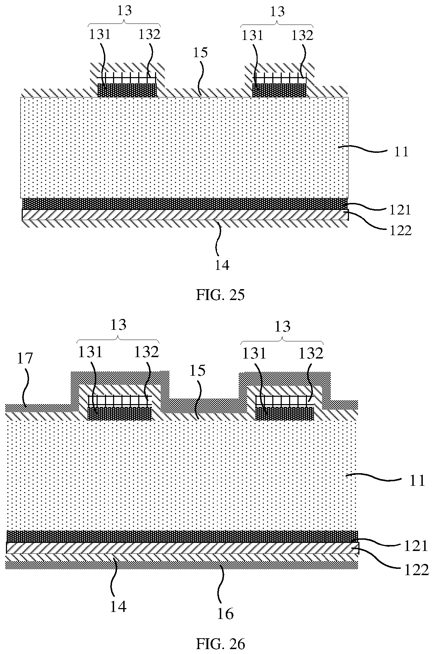

Subsequently, a first passivation layer 14 is formed on the first surface 11a, and a second passivation layer 15 is formed on the second surface 11b. The structure obtained after forming the first passivation layer 14 and the second passivation layer 15 is shown in FIG. 25.

Next, a first anti-reflective layer 16 is formed on the first surface 11a, and a second anti-reflective layer 17 is formed on the second surface 11b. The structure obtained after forming the first anti-reflective layer 16 and the second anti-reflective layer 17 is shown in FIG. 26.

Following the above, first electrodes 18 are formed on the first surface 11a, passing through the first passivation layer 14 and the first anti-reflective layer 16 and coming into electrically contact with the first passivation contact layer 122; and second electrodes 19 are formed on the second surface 11b, passing through the second passivation layer 15 and the second anti-reflective layer 17 and coming into electrically contact with the second passivation contact layers 132, respectively. The structure obtained after forming the first electrodes 18 and the second electrodes 19 are shown in FIG. 27.

The method for preparing the solar cell provided by the present application does not require the large-area laser etching, which can reduce the preparation cost of the solar cell 1. Additionally, the semiconductor substrate 11 is subjected to only one texturing step, which can reduce the reflectivity difference between the passivation contact regions 11b1 and the passivation regions 11b2.

### Example 2

A method for preparing a solar cell includes the following steps.

An n-type semiconductor substrate 11 is provided. The semiconductor substrate 11 includes a first surface 11a and a second surface 11b opposite each other, and further includes a third surface 11c connecting the first surface 11a and the second surface 11b. The second surface 11b includes passivation contact regions 11b1 and passivation regions 11b2 alternately arranged and adjacent to each other.

The semiconductor substrate 11 is polished. The polished semiconductor substrate 11 is shown in FIG. 13.

A first tunnel material layer 21 is formed on the first surface 11a, the second surface 11b, and the third surface 11c.

A first passivation contact material layer 22 is formed on the first tunnel material layer 21 by LPCVD. The structure obtained after the formation of the first passivation contact material layer 22 and the first tunnel material layer 21 is shown in FIG. 14.

The first passivation contact material layer 22 is subjected to a first heat treatment to diffuse a p-type dopant into the first passivation contact material layer 22. A diffusion source layer may be or may be not previously formed on the first passivation contact material layer 22 for performing the dopant diffusion. During the first heat treatment, the first passivation contact material layer 22 is oxidized, thereby forming the first medium layer 23 simultaneously on the first passivation contact material layer 22. In the present example, the dopant is a boron element. The structure obtained after the first heat treatment is shown in FIG. 15.

The semiconductor substrate 11 is washed with acid to remove the first medium layer 23 from the second surface 11b and the third surface 11c, while the first medium layer 23 on the first surface 11a is retained. Specifically, a hydrofluoric acid solution is used for acid washing. The structure obtained after acid washing is shown in FIG. 16.

The semiconductor substrate 11 is then polished to remove the first passivation contact material layer 22 and the first tunnel material layer 21 from the second surface 11b and the third surface 11c. Specifically, an alkaline solution containing sodium hydroxide is used for polishing. Under the protection of the first medium layer 23 on the first surface 11a, the first passivation contact material layer 22 and the first tunnel material layer 21 on the first surface 11a are retained. The polished structure is shown in FIG. 17.

The polished semiconductor substrate 11 is textured to form pyramidal textured structures in the second surface 11b.

A second tunnel material layer 24 is then formed on the second surface 11b and the third surface 11c of the semiconductor substrate 11.

After that, a second passivation contact material layer 25 doped with an n-type dopant is formed on the first surface 11a, the second surface 11b, and the third surface 11c by PECVD; that is, the second passivation contact material layer 25 is formed with in-situ doping.

Then a second medium layer 26 is formed on the second passivation contact material layer 25. The second medium layer 26 can be simultaneously formed by introducing oxygen at a latter stage of the PECVD process, without a separate heat treatment step. The structure obtained after forming the second tunnel material layer 24, the second passivation contact material layer 25, and the second medium layer 26 is shown in FIG. 28.

The semiconductor substrate 11 is washed with acid to entirely remove the second medium layer 26. Specifically, a hydrofluoric acid solution is used for acid washing. The structure obtained after acid washing is shown in FIG. 29.

The local areas of the surface of the second passivation contact material layer 25 on the second surface 11b are oxidized to form a mask layer 27. The local areas are in alignment with the passivation contact regions 11b1. Specifically, an ultraviolet picosecond laser is adopted to perform the oxidation. The structure obtained after the oxidation is shown in FIG. 30.

After that, through the mask layer 27, the second tunnel material layer 24 and the second passivation contact material layer 25 on the second surface 11b and located in the passivation regions 11b2 are removed. Specifically, the second passivation contact material layer 25 is removed from the passivation regions 11b2, the first surface 11a, and the third surface 11c by using an alkaline solution containing potassium hydroxide. Then, the second tunnel material layer 24 is removed from the passivation regions 11b2, the first surface 11a, and the third surface 11c by using an acid solution containing hydrofluoric acid. In this step, the first medium layer 23 can be simultaneously removed from the first surface 11a with the second tunnel material layer 24. The structure obtained after this step is shown in FIG. 31. Under the protection of the mask layer 27, the second tunnel material layers 24 and the second passivation contact material layers 25 on the second surface 11b and located in the passivation contact regions 11b1 can be retained.

Following the above, the first tunneling passivation structure 12, the second tunnel material layers 24, and the second passivation contact material layers 25, retained on the semiconductor substrate 11 are subjected to a fourth heat treatment. In this step, on the one hand, the second passivation contact material layers 25 can be crystallized; on the other hand, the dopant within the second passivation contact material layers 25 can be activated. Referring to FIG. 32, a heat treatment by-product 28 can be formed on the semiconductor substrate 11 during the fourth heat treatment. In some embodiments, the temperature of the fourth heat treatment can be in a range from 900°C to 930°C.

Then the semiconductor substrate 11 is washed with acid to remove the heat treatment by-product 28 from the semiconductor substrate 11. Specifically, the thermal treatment by-products 28 can be removed by using a hydrofluoric acid solution. The structure obtained after acid washing is shown in FIG. 33.

Subsequently, a first passivation layer 14 is formed on the first surface 11a, and a second passivation layer 15 is formed on the second surface 11b. The structure obtained after forming the first passivation layer 14 and the second passivation layer 15 is shown in FIG. 25.

Next, a first anti-reflective layer 16 is formed on the first surface 11a, and a second anti-reflective layer 17 is formed on the second surface 11b. The structure obtained after forming the first anti-reflective layer 16 and the second anti-reflective layer 17 is shown in FIG. 26.

Following the above, first electrodes 18 are formed on the first surface 11a, passing through the first passivation layer 14 and the first anti-reflective layer 16 and coming into electrically contact with the first passivation contact layer 122; and second electrodes 19 are formed on the second surface 11b, passing through the second passivation layer 15 and the second anti-reflective layer 17 and coming into electrically contact with the second passivation contact layers 132 respectively. The structure obtained after forming the first electrodes 18 and the second electrodes 19 are shown in FIG. 27.

The method for preparing the solar cell provided by the present application does not require the large-area laser etching, which can reduce the preparation cost of the solar cell 1. Additionally, the semiconductor substrate 11 is subjected to only one texturing step, which can reduce the reflectivity difference between the passivation contact regions 11b1 and the passivation regions 11b2. Moreover, in contrast with post-doping a previously formed second passivation contact material layer, the second passivation contact material layer 25 is in-situ doped, preventing dopant diffusion into the side edges namely the third surface 11c of the semiconductor substrate 11, which improves passivation on the edges of the solar cell 1.

### Example 3

A method for preparing a solar cell includes the following steps.

An n-type semiconductor substrate 11 is provided. The semiconductor substrate 11 includes a first surface 11a and a second surface 11b opposite each other, and further includes a third surface 11c connecting the first surface 11a and the second surface 11b. The second surface 11b includes passivation contact regions 11b1 and passivation regions 11b2 alternately arranged and adjacent to each other.

The semiconductor substrate 11 is polished. The polished semiconductor substrate 11 is shown in FIG. 13.

A first tunnel material layer 21 is formed on the first surface 11a, the second surface 11b, and the third surface 11c.

A first passivation contact material layer 22 doped with a p-type dopant is formed on the first tunnel material layer 21 by PECVD, that is, the first passivation contact material layer 22 is formed with in-situ doping.

A first medium layer 23 is formed on the first passivation contact material layer 22. The first medium layer 23 can be simultaneously formed by introducing oxygen at a latter stage of the PECVD process, without a separate heat treatment step. The structure obtained after forming the first tunnel material layer 21, the first passivation contact material layer 22, and the first medium layer 23 is shown in FIG. 35.

The semiconductor substrate 11 is washed with acid to remove the first medium layer 23 from the second surface 11b and the third surface 11c, while the first medium layer 23 on the first surface 11a is retained. Specifically, a hydrofluoric acid solution is used for acid washing. The structure obtained after acid washing is shown in FIG. 16.

The semiconductor substrate 11 is then polished to remove the first passivation contact material layer 22 and the first tunnel material layer 21 from the second surface 11b and the third surface 11c. Specifically, an alkaline solution containing sodium hydroxide is used for polishing. The polished structure is shown in FIG. 17.

The polished semiconductor substrate 11 is textured to form pyramidal textured structures in the second surface 11b.

A second tunnel material layer 24 is then formed on the second surface 11b and the third surface 11c of the semiconductor substrate 11.

After that, a second passivation contact material layer 25 doped with an n-type dopant is formed on the first surface 11a, the second surface 11b, and the third surface 11c by PECVD; that is, the second passivation contact material layer 25 is formed with in-situ doping.

A second medium layer 26 is formed on the second passivation contact material layer 25. The second medium layer 26 can be simultaneously formed by introducing oxygen at a latter stage of the PECVD process, without a separate heat treatment step. The structure obtained after forming the second tunnel material layer 24, the second passivation contact material layer 25, and the second medium layer 26 is shown in FIG. 28.

The semiconductor substrate 11 is washed with acid to entirely remove the second medium layer 26. The structure obtained after acid washing is shown in FIG. 29.

The local areas of the surface of the second passivation contact material layer 25 on the second surface 11b are oxidized to form a mask layer 27. The local areas are in alignment with the passivation contact regions 11b1. Specifically, an ultraviolet picosecond laser is adopted to perform the oxidation. The structure obtained after the oxidation is shown in FIG. 30.

After that, through the mask layer 27, the second tunnel material layer 24 and the second passivation contact material layer 25 on the second surface 11b and located in the passivation regions 11b2 are removed. Specifically, the second passivation contact material layer 25 is removed from the passivation regions 11b2, the first surface 11a, and the third surface 11c by using an alkaline solution containing potassium hydroxide. Then, the second tunnel material layer 24 is removed from the passivation regions 11b2, the first surface 11a, and the third surface 11c by using an acid solution containing hydrofluoric acid. In this step, the first medium layer 23 can be simultaneously removed from the first surface 11a with the second tunnel material layer 24. The structure obtained after this step is shown in FIG. 31. Under the protection of the mask layer 27, the second tunnel material layers 24 and the second passivation contact material layers 25 on the second surface 11b and located in the passivation contact regions 11b1 can be retained.

Following the above, the first tunneling passivation structure 12, the second tunnel material layers 24, and the second passivation contact material layers 25, retained on the semiconductor substrate 11 are subjected to a fourth heat treatment. In this step, on the one hand, the first passivation contact material layer 22 and the second passivation contact material layers 25 can be crystallized; on the other hand, the dopants within the first passivation contact material layer 22 and the second passivation contact material layers 25 can be activated. Referring to FIG. 32, a heat treatment by-product 28 can be formed on the semiconductor substrate 11 during the fourth heat treatment.

Then the semiconductor substrate 11 is washed with acid to remove the heat treatment by-product 28 from the semiconductor substrate 11. Specifically, the thermal treatment by-products 28 can be removed by using a hydrofluoric acid solution. The structure obtained after acid washing is shown in FIG. 33.

Subsequently, a first passivation layer 14 is formed on the first surface 11a, and a second passivation layer 15 is formed on the second surface 11b. The structure obtained after forming the first passivation layer 14 and the second passivation layer 15 is shown in FIG. 25.

Next, a first anti-reflective layer 16 is formed on the first surface 11a, and a second anti-reflective layer 17 is formed on the second surface 11b. The structure obtained after forming the first anti-reflective layer 16 and the second anti-reflective layer 17 is shown in FIG. 26.

Following the above, first electrodes 18 are formed on the first surface 11a, passing through the first passivation layer 14 and the first anti-reflective layer 16 and coming into electrically contact with the first passivation contact layer 122; and second electrodes 19 are formed on the second surface 11b, passing through the second passivation layer 15 and the second anti-reflective layer 17 and coming into electrically contact with the second passivation contact layers 132 respectively. The structure obtained after forming the first electrodes 18 and the second electrodes 19 is shown in FIG. 27.

The method for preparing the solar cell provided by the present application does not require the large-area laser etching, which can reduce the preparation cost of the solar cell 1. Additionally, the semiconductor substrate 11 is subjected to only one texturing step, which can reduce the reflectivity difference between the passivation contact regions 11b1 and the passivation regions 11b2. Moreover, only one heat treatment step is performed in the present method to crystallize the first passivation contact material layer 22 and the second passivation contact material layers 25 at the same time, and to activate the dopants in the first passivation contact material layer 22 and the second passivation contact material layers 25 at the same time, which can further reduce the preparation cost of the solar cell 1.

### Example 4

A method for preparing a solar cell includes the following steps.

An n-type semiconductor substrate 11 is provided. The semiconductor substrate 11 includes a first surface 11a and a second surface 11b opposite each other, and further includes a third surface 11c connecting the first surface 11a and the second surface 11b. The second surface 11b includes passivation contact regions 11b1 and passivation regions 11b2 alternately arranged and adjacent to each other.

The semiconductor substrate 11 is polished.

A first tunnel material layer 21 is formed on the first surface 11a, the second surface 11b, and the third surface 11c.

A first passivation contact material layer 22 doped with a p-type dopant is formed on the first tunnel material layer 21 by PECVD, that is, the first passivation contact material layer 22 is formed with in-situ doping.

A first medium layer 23 is formed on the first passivation contact material layer 22. The first medium layer 23 can be simultaneously formed by introducing oxygen at a latter stage of the PECVD process, without a separate heat treatment step.

The semiconductor substrate 11 is washed with acid to remove the first medium layer 23 from the second surface 11b and the third surface 11c, while the first medium layer 23 on the first surface 11a is retained. Specifically, a hydrofluoric acid solution is used for acid washing.

The semiconductor substrate 11 is then polished to remove the first passivation contact material layer 22 and the first tunnel material layer 21 from the second surface 11b and the third surface 11c. Specifically, an alkaline solution containing sodium hydroxide is used for polishing.

The polished semiconductor substrate 11 is textured to form pyramidal textured structures in the second surface 11b.

A second tunnel material layer 24 is then formed on the second surface 11b and the third surface 11c of the semiconductor substrate 11.

A first passivation contact material sub-layer 251 is then formed on the first surface 11a and the second surface 11b.

A barrier material layer 252 is then formed on the first passivation contact material sub-layer 251.

A second passivation contact material sub-layer 253 is then formed on the barrier material layer 252, so as to form the second passivation contact material layer 25. The structure obtained after forming the first passivation contact material sub-layer 251, the barrier material layer 252, and the second passivation contact material sub-layer 253 is shown in FIG. 34.

A second medium layer 26 is formed on the second passivation contact material layer 25.

The first tunneling passivation structure 12, the second tunnel material layer 24, and the second passivation contact material layer 25 are then subjected to a third heat treatment.

The semiconductor substrate 11 is washed with acid to remove the second medium layer 26 from the first surface 11a and the third surface 11c, while the second medium layer 26 on the second surface 11b is retained. Specifically, a hydrofluoric acid solution is used for acid washing.

The semiconductor substrate 11 is then polished to remove the second passivation contact material layer 25 from the first surface 11b and the third surface 11c and to remove the first tunnel material layer 21 from the third surface 11c. Specifically, an alkaline solution containing sodium hydroxide is used for polishing. Under the protection of the second medium layer 26 on the second surface 11b, the second passivation contact material layer 25 and the second tunnel material layer 24 on the second surface 11b are retained.

After that, the semiconductor substrate 11 is washed with acid to remove the second medium layer 26 from the second surface 11b. Specifically, a hydrofluoric acid solution is used for acid washing.

The local areas of the surface of the second passivation contact material layer 25 are oxidized to form a mask layer 27. The local areas are in alignment with the passivation contact regions 11b1. Specifically, an ultraviolet picosecond laser is adopted to perform the oxidation.

Through the mask layer 27, the second passivation contact material layer 25 located in the passivation regions 11b2 is thinned, thereby forming the second tunneling passivation structures 13 located in the passivation contact regions 11b1, and forming third tunnel layers 110 and third passivation layers 111 stacked in the passivation regions 11b2. Specifically, the second passivation contact material layer 25 is thinned by using an alkaline solution containing potassium hydroxide.

Subsequently, a first passivation layer 14 is formed on the first surface 11a, and a second passivation layer 15 is formed on the second surface 11b.

Next, a first anti-reflective layer 16 is formed on the first surface 11a, and a second anti-reflective layer 17 is formed on the second surface 11b.

Following the above, first electrodes 18 are formed on the first surface 11a, passing through the first passivation layer 14 and the first anti-reflective layer 16 and coming into electrically contact with the first passivation contact layer 122; and second electrodes 19 are formed on the second surface 11b, passing through the second passivation layer 15 and the second anti-reflective layer 17 and coming into electrically contact with the second passivation contact layers 132, respectively.

The method for preparing the solar cell provided by the present application does not require the large-area laser etching, which can reduce the preparation cost of the solar cell 1. Additionally, the semiconductor substrate 11 is subjected to only one texturing step, which can reduce the reflectivity difference between the passivation contact regions 11b1 and the passivation regions 11b2. Moreover, only one heat treatment step is performed in the present method to crystallize the first passivation contact material layer 22 and the second passivation contact material layers 25 at the same time, and to activate the dopants in the first passivation contact material layer 22 and the second passivation contact material layers 25 at the same time, which can further reduce the preparation cost of the solar cell 1. In addition, the stack of the third tunneling layer 110 and the third passivation layer 111 is formed in the passivation regions 11b2, which can improve the passivation effect of the solar cell 1, making the passivation interface more stable. In UV testing of the solar cell, this configuration can reduce the degradation of the solar cell 1. The third passivation layer 111, which is formed from thinning the second passivation contact material layer 25, is relatively thin, reducing the light absorption of the third passivation layer 111, and thereby enhancing the efficiency of the solar cell 1.

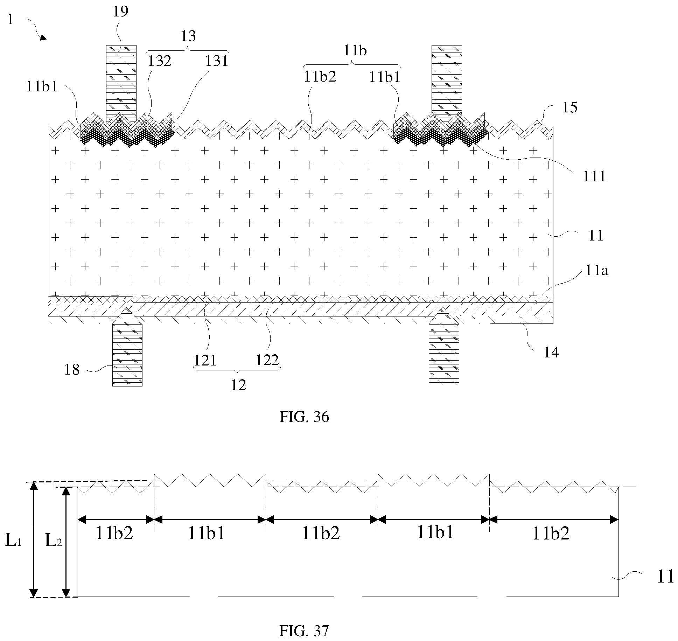

Referring to FIGs. 36 and 37, an embodiment of the present application provides a solar cell 1, which can be prepared by any one of the above embodiments of the method.

The solar cell 1 includes an n-type semiconductor substrate, a first tunneling passivation structure 12, and a second tunneling passivation structure 13. The semiconductor substrate 11 includes a first surface 11a and a second surface 11b opposite to each other. The second surface 11b includes a passivation contact region 11b1 and a passivation region 11b2 adjacent to each other. The first tunneling passivation structure 12 is disposed on the first surface 11a. The first tunneling passivation structure 12 includes a first tunnel layer 121 and a first passivation contact layer 122 stacked in a direction away from the semiconductor substrate 11. The doping type of the first passivation contact layer is p-type. The second tunneling passivation structure 13 is disposed on the second surface 11b and located in the passivation contact region 11b1 of the second surface 11b. The second tunneling passivation structure 13 includes a second tunnel layer 131 and a second passivation contact layer 132 stacked on the passivation contact region 11b1.

When forming the second tunneling passivation structure 13, the surface of the second passivation contact material layer 25 located in the passivation contact region 11b1 is oxidized to form a mask layer 27. The second tunneling passivation structure 13 is formed by processing the second passivation contact material layer 25 located in the passivation region 11b2 through the mask layer 27.

In some embodiments, the second surface 11b includes a plurality of passivation contact regions 11b1 and a plurality of passivation regions 11b2 adjacent to each other. The passivation contact regions 11b1 and the passivation regions 11b2 are alternately arranged. The solar cell includes a plurality of second tunneling passivation structures 13, respectively located in the passivation contact regions 11b1 in the one-to-one manner.

In some embodiments, the first surface 11a corresponds to the back face of the solar cell 1, which is away from the sun in operation, the second surface 11b corresponds to the front face of the solar cell 1, which faces the sun in operation. As such, the first tunneling passivation structure 12 can be the back tunneling passivation contact structure, and the second tunneling passivation structures 13 can be the front tunneling passivation contact structures. In the present application, by forming the bifacial tunneling passivation structure in the solar cell 1, an excellent surface passivation can be provided on both the front and back sides of the semiconductor substrate 11, reducing the recombination current due to the metal contact, so as to increase the open-circuit voltage and short-circuit current, and improve the efficiency of the solar cell 1. Moreover, the solar cell 1 provided in the embodiments can also reduce the preparation cost.

In addition, the p-n junction of the solar cell 1 in the embodiments of the present application is located at the back side of the solar cell 1, which is more suitable for improving the efficiency of the solar cell 1 compared to that located at the front side of the solar cell 1.

In some embodiments, a first distance between the passivation contact region 11b1 of the second surface 11b and the first surface 11a is represented by L1, and a second distance between the passivation region 11b2 of the second surface 11b and the first surface 11a is represented by L₂, L₁ and L₂ satisfy 0 ≤ L₁-L₂ ≤ 1 µm. L₁-L₂ is the height difference between the passivation contact region 11b1 and the passivation region 11b2. By controlling the height difference between the passivation contact region 11b1 and the passivation region 11b2 to be in the above range, the uniformity of the reflectance of the solar cell 1 can further be improved.

In some embodiments, both the passivation contact regions 11b1 and the passivation regions 11b2 are textured into pyramidal textured structures. In an embodiment, the first distance is the average height of the pyramidal textured structures in the passivation contact region 11b1 relative to the first surface 11a, and the second distance is the average height of the pyramidal textured structures in the passivation region 11b2 relative to the first surface 11a. In another embodiment, the first distance is the maximum height of the pyramidal textured structures in the passivation contact region 11b1 relative to the first surface 11a, and the second distance is the maximum height of the pyramidal textured structures in the passivation region 11b2 relative to the first surface 11a. In yet another example, the first distance is the minimum height of the pyramidal textured structures in the passivation contact region 11b1 relative to the first surface 11a, and the second distance is the minimum height of the pyramidal textured structures in the passivation region 11b2 relative to the first surface 11a.

In related art, to form a plurality of second tunneling passivation structures 13 spaced apart from each other on the front surface of the semiconductor substrate 11, a BSG or PSG layer may be previously formed on the entire second passivation contact material layer 25, and then the BSG or PSG layer can be laser etched to form the mask layer, thereby forming a mask layer on the semiconductor substrate 11 by the borosilicate glass or phosphosilicate glass remaining on the semiconductor substrate 11. The energy of the laser etching may be relatively high, which may cause damage on the surface area of the semiconductor substrate 11 corresponding to the laser etched area of the BSG or PSG layer. Thus, in the following step of forming the second tunneling passivation structure 13 through the mask layer, the semiconductor substrate 11 may need to be wet etched to remove the damaged surface area of the semiconductor substrate 11, during which the pyramidal textured structures in the passivation region 11b2 may be destructed. As a result, an additional texturing step is required to recreate new pyramidal textured structures in the passivation region 11b2. These processes result in a height difference, which is equal to or greater than 2µm, between the laser etched area and the rest area of the semiconductor substrate 11, which not only affects the efficiency of the solar cell 1 but also reduces the uniformity of the solar cell 1.

In contrast, in the embodiments of the present application, referring to FIGs. 23 and 24, the mask layer 27 is formed by locally oxidizing the second passivation contact material layer 25 with a laser, which reduces preparation cost and causes no damages to the passivation regions 11b2. Thus, there is no need to further etch the passivation regions 11b2 to remove damaged structures, nor to perform a second texturing process on the etched passivation regions 11b2. As such, the height difference between the passivation contact region 11b1 and the passivation region 11b2 can be less than or equal to 1 µm.

In some embodiments, the thickness of the second passivation contact layer 132 is in a range from 90 nm to 300 nm. For example, the thickness of the second passivation contact layer 132 can be 90 nm, 110 nm, 150 nm, 190 nm, 240 nm, 280 nm, 300 nm, or any value therebetween.

The thickness of the second passivation contact layer 132 refers to the distance between the surface of the second passivation contact layer 132 adjacent to the semiconductor substrate 11 and the surface of the second passivation contact layer 132 away from the semiconductor substrate 11.

In some specific embodiments, the thickness of the second passivation contact layer 132 is in a range from 90 nm to 299 nm. For example, the thickness of the second passivation contact layer 132 can be 90 nm, 110 nm, 150 nm, 190 nm, 240 nm, 280 nm, 299 nm, or any value therebetween.

In related art, a thickness of a second passivation contact layer is typically in a range from 100 nm to 300 nm. However, in the embodiments of the present application, the second passivation contact material layer 25 is oxidized by laser to form the mask layer 27, and the mask layer 27 will be removed in a subsequent step. Thus, the thickness of the formed second passivation contact layer 132 will be reduced. Optionally, the thickness is reduced by 1 nm to 10 nm based on the original thickness of the second passivation contact material layer 25. Therefore, in the embodiments of the present application, the thickness of the second passivation contact layer 132 is 1 nm to 10 nm thinner than the thickness of the second passivation contact layer in the related art.

In some embodiments, both the first passivation contact layer 122 and the second passivation contact layer 132 are made of doped polysilicons, and the doping types of the first passivated contact layer 122 and the second passivated contact layer 132 are opposite to each other.

In some embodiments, referring to FIG. 38, the semiconductor substrate 11 includes a first diffusion region 11d, and an orthographic projection of the second tunneling passivation structure 13 projected on the semiconductor substrate 11 overlaps with the first diffusion region 11d. Thus, a doping concentration difference can be formed within the semiconductor substrate 11.

In some embodiments, referring to FIG. 38, the semiconductor substrate 11 includes a second diffusion region 11e. The second diffusion region 11e is in contact with the first diffusion region 11d. An orthographic projection of the second tunneling passivation structure 13 projected on the semiconductor substrate 11 does not overlap with the second diffusion region 11e. By retaining the second diffusion region 11e in the semiconductor substrate 11, the passivation effect of the solar cell 1 can be improved, making the passivation interface more stable, and the degradation of the solar cell 1 in the UV testing can be reduced.

In some embodiments, referring to FIG. 39, the solar cell 1 further includes a third tunnel layer 110 and a third passivation layer 111, which are stacked in the passivation region 11b2 of the second surface 11b. The third tunnel layer 110 and third passivation layer 111 are disposed between the semiconductor substrate 11 and the second passivation layer 15. The third passivation layer 111 is disposed between the third tunnel layer 110 and the second passivation layer 15. By forming the third tunnel layer 110 and the third passivation layer 111 stacked in the passivation region 11b2, the passivation effect of the solar cell 1 is further enhanced, the passivation interface becomes more stable, and during UV testing, the attenuation of the solar cell 1 is minimized.

In some embodiments, the third tunnel layer 110 and the second tunnel layer 131 are an integrated structure. To achieve the integrated structure, the material for the third tunnel layer 110 and the material for the second tunnel layer 131 can be simultaneously deposited on the semiconductor substrate 11 in the same process, thereby reducing the complexity of manufacturing.

In some embodiments, the third passivation layer 111 and the second passivation contact layer 132 are an integrated structure. To achieve the integrated structure, the material for the third passivation layer 111 and the material for the second passivation contact layer 132 can be simultaneously deposited on the semiconductor substrate 11 in the same process, thereby reducing the complexity of manufacturing.

In some embodiments, the thickness of the third passivation layer 111 is less than that of the second passivation contact layer 132. The thickness of the third passivation layer 111 refers to the distance between the surface of the third passivation layer 111 adjacent to the semiconductor substrate 11 and the surface of the third passivation layer 111 away from the semiconductor substrate 11. Similarly, the thickness of the second passivation contact layer 132 refers to the distance between the surface of the second passivation contact layer 132 adjacent to the semiconductor substrate 11 and the surface of the second passivation contact layer 132 away from the semiconductor substrate 11.

In the above structure, the thickness of the third passivation layer 111 can be relatively thin, thereby reducing the light absorption of the third passivation layer 111, which can improve the efficiency of the solar cell 1.

In some embodiments, a ratio of the thickness of the second passivation contact layer 132 to the thickness of the third passivation layer 111 is in a range from 5 to 30, which can further reduce the light absorption of the third passivation layer 111, thereby improving the efficiency of the solar cell 1, and on the other hand, can improve the passivation contact effect of the second passivation contact layer 132, thereby also improving the efficiency of the solar cell 1.

In some embodiments, the thickness of the third passivation layer 111 is in a range from 10nm to 20nm. For example, the thickness of the third passivation layer 111 can be 10nm, 15nm, 20nm, or any value therebetween, which can further reduce the light absorption of the third passivation layer 111, thereby improving the efficiency of the solar cell 1.

In some embodiments, the thickness of the second passivation contact layer 132 is in a range from 100nm to 300nm. For example, the thickness of the second passivation contact layer 132 can be 100nm, 150nm, 190nm, 230nm, 180nm, 300nm, or any value therebetween, which can improve the passivation contact effect of the second passivation contact layer 132, thereby also improving the efficiency of the solar cell 1.

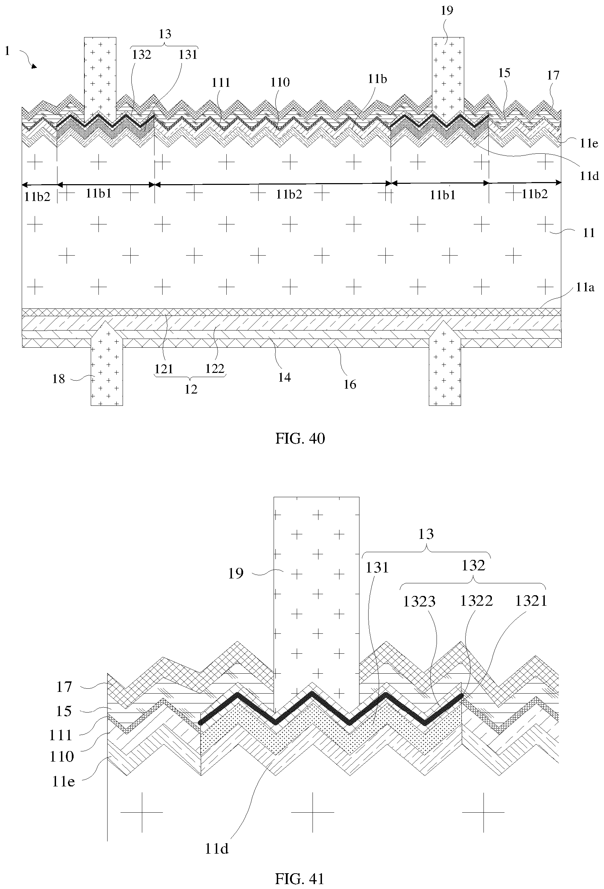

In some embodiments, referring to FIGs. 40 and 41, the second passivation contact layer 132 includes a first passivation contact sub-layer 1321, a barrier layer 1322, and a second passivation contact sub-layer 1323, stacked in a direction away from the semiconductor substrate 11.

By arranging the barrier layer 1322 between the first passivation contact sub-layer 1321 and the second passivation contact sub-layer 1323, over etching in the wet etching can be avoided, and a relatively thin third passivation layer 111 can be easily formed. In addition, during the metallization process for forming the electrodes, the barrier layer 1322 can reduce the diffusion of metal into the semiconductor substrate 11, thereby reducing charge carrier recombination and improving the efficiency of the solar cell 1.

In some embodiments, the solar cell 1 further includes a first electrode 18 and a second electrode 19. The first electrode 18 is electrically connected to the first tunneling passivation structure 12, and the second electrode 19 is electrically connected to the second tunneling passivation structure 13.

In some embodiments, the solar cell 1 further includes a first passivation layer 14 and a second passivation layer 15. The first passivation layer 14 is located on the first surface 11a, and the second passivation layer 15 is located on the second surface 11b.

In some embodiment, the solar cell 1 further includes a first anti-reflective layer 16 and a second anti-reflective layer 17. The first anti-reflective layer 16 is located on the first passivation layer 14, and the second anti-reflective layer 17 is located on the second passivation layer 15.

In some embodiments, the first tunneling passivation structure 12 is in contact with the first surface 11a, and the second tunneling passivation structure 13 is in contact with the passivation contact region 11b1 of the second surface 11b. This structure not only reduces the contact resistance but also improves the passivation effect.

An embodiment of the present application provides a photovoltaic module, including the solar cell described in any one of the above embodiments.

In some embodiments, the photovoltaic module includes a plurality of solar cells 1, which can be connected in series through a welding strip, so as to collect the electric energy generated by separate solar cells 1 for subsequent transmission. The solar cells 1 can be arranged at intervals, or can be stacked together in an imbricated form.

In some embodiments, the photovoltaic module further includes an encapsulation layer and a cover plate (not shown in the drawings). The encapsulation layer is configured to cover the surface of a group of cells. The cover plate is configured to cover the surface of the encapsulation layer away from the cells. The solar cells 1 are electrically connected into a whole piece or multiple pieces, to form a plurality of cell groups. The plurality of cell groups are electrically connected in series and/or in parallel. Specifically, in some embodiments, the plurality of cell groups can be electrically connected through conductive strips. The encapsulation layer covers the surface of the solar cells. In some embodiments, the encapsulation layer can be an organic encapsulation film, such as an ethylene-vinyl acetate copolymer film, a polyethylene-octene elastomer film, or a polyethylene terephthalate film. The cover plate may be, for example, a glass cover plate, a plastic cover plate, or the like with a light-transmitting function.

An embodiment of the present application provides a photovoltaic system, including the photovoltaic module in any one of the above embodiments.

The photovoltaic system can be applied to photovoltaic power stations, such as ground power stations, roof power stations, water surface power stations, etc. Alternatively, the photovoltaic system can be applied to equipment or devices that use solar energy to generate electricity, such as user solar power supplies, solar street lights, solar cars, solar buildings, etc. It can be understood that the application scenarios of the photovoltaic system are not limited to the above, that is, the photovoltaic system can be applied in all fields that need to use solar energy to generate electricity. Taking a photovoltaic power generation network as an example, the photovoltaic system can include photovoltaic arrays, a combiner box, and an inverter. The photovoltaic array can be an array of multiple photovoltaic modules 200. For example, the multiple photovoltaic modules 200 can form multiple photovoltaic arrays. The photovoltaic arrays are connected to the combiner box, which can combine the currents generated by the photovoltaic arrays. The combined current flows through the inverter and is converted into the alternating current suitable for the power grid, and then connected to the power grid to realize solar power supply.

## Claims

1. A solar cell, comprising:
an n-type semiconductor substrate (11) comprising a first surface (11a) and a second surface (11b) opposite to each other, the second surface comprising a passivation contact region (11b1) and a passivation region (11b2) adjacent to each other;
a first tunneling passivation structure (12) disposed on the first surface, the first tunneling passivation structure comprising a first tunnel layer (121) and a first passivation contact layer (122) stacked in a direction away from the semiconductor substrate, a doping type of the first passivation contact layer is p-type;
a second tunneling passivation structure (13) disposed on the second surface and located in the passivation contact region of the second surface, the second tunneling passivation structure comprising a second tunnel layer (131) and a second passivation contact layer (132) stacked on the passivation contact region; and
a third tunnel layer (110) and a third passivation layer (111) stacked on the passivation region of the second surface, a thickness of the third passivation layer being less than a thickness of the second passivation contact layer.

2. The solar cell according to claim 1, wherein a first distance between the passivation contact region of the second surface and the first surface is represented by L₁, and a second distance between the passivation region of the second surface and the first surface is represented by L₂, L₁ and L₂ satisfy 0 ≤ L₁-L₂ ≤ 1 µm.

3. The solar cell according to claim 1 or 2, wherein a thickness of the second passivation contact layer is in a range from 90 nm to 300 nm.

4. The solar cell according to any one of claims 1 to 3, wherein the semiconductor substrate comprises a first diffusion region (11d), and an orthographic projection of the second tunneling passivation structure projected on the semiconductor substrate overlaps with the first diffusion region.

5. The solar cell according to claim 4, wherein the semiconductor substrate comprises a second diffusion region (11e), the second diffusion region is in contact with the first diffusion region, and an orthographic projection of the second tunneling passivation structure projected on the semiconductor substrate does not overlap with the second diffusion region.

6. The solar cell according to claim 1, wherein the third tunnel layer and the second tunnel layer are one integrated structure; and/or
the third passivation layer and the second passivation contact layer are one integrated structure.

7. The solar cell according to any one of claims 1 to 6, wherein a thickness ratio of the second passivation contact layer to the third passivation layer is in a range from 5 to 30.

8. The solar cell according to any one of claims 1 to 7, wherein the thickness of the third passivation layer is in a range from 10nm to 20nm.

9. The solar cell according to any one of claims 1 to 8, wherein the second passivation contact layer comprises a first passivation contact sub-layer (1321), a barrier layer (1322), and a second passivation contact sub-layer (1323), stacked in a direction away from the semiconductor substrate.

10. The solar cell according to claim 9, wherein the barrier material layer is made of silicon dioxide, the first passivation contact sub-layer and the second passivation contact sub-layer are made of doped polysilicon.

11. The solar cell according to any one of claims 1 to 10, wherein the second surface in both the passivation contact region and the passivation region comprises pyramidal textured structures.

12. The solar cell according to any one of claims 1 to 11, further comprising a first electrode (18) and a second electrode (19), wherein the first electrode is electrically connected to the first tunneling passivation structure, and the second electrode is electrically connected to the second tunneling passivation structure.

13. The solar cell according to claim 1, further comprising a first passivation layer (14), a second passivation layer (15), a first anti-reflective layer (16) and a second anti-reflective layer (17), wherein the first passivation layer is located on the first surface, and the second passivation layer is located on the second surface; the first anti-reflective layer is located on the first passivation layer, and the second anti-reflective layer is located on the second passivation layer.

14. A photovoltaic module, comprising the solar cell according to any one of claims 1 to 13.

15. A photovoltaic system, comprising the photovoltaic module according to claim 14.
